(19) Europäisches Patentamt
European Patent Office
Office européen des brevets

(11) **EP 2 909 932 B1**

(12) **FASCICULE DE BREVET EUROPEEN**

(45) Date de publication et mention de la délivrance du brevet:
**21.09.2016 Bulletin 2016/38**

(21) Numéro de dépôt: **13779770.0**

(22) Date de dépôt: **09.10.2013**

(51) Int Cl.:
***H03H 9/02*** *(2006.01)*

(86) Numéro de dépôt international:
**PCT/EP2013/071050**

(87) Numéro de publication internationale:
**WO 2014/060263 (24.04.2014 Gazette 2014/17)**

(54) **TRANSDUCTEUR A ONDES DE VOLUME GUIDEES EN SURFACE PAR DES STRUCTURES D'EXCITATION SYNCHRONE**

WANDLER MIT DURCH SYNCHRONE ANREGUNGSSTRUKTUREN GEFÜHRTEN VOLUMENWELLEN

TRANSDUCER WITH BULK WAVES SURFACE-GUIDED BY SYNCHRONOUS EXCITATION STRUCTURES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.10.2012 FR 1260005**

(43) Date de publication de la demande:
**26.08.2015 Bulletin 2015/35**

(73) Titulaires:
• **Centre National de la Recherche Scientifique (CNRS)**
**75016 Paris (FR)**
• **Université de Franche-Comté**
**25030 Besançon Cedex (FR)**

(72) Inventeurs:
• **BALLANDRAS, Sylvain**
**F-25000 Besançon (FR)**
• **PLESSKI, Viktor**
**CH-2025 Gorgier (CH)**

(74) Mandataire: **Lavoix**
**2, place d'Estienne d'Orves**
**75441 Paris Cedex 09 (FR)**

(56) Documents cités:
**DE-A1-102007 012 383    FR-A1- 2 938 136**

EP 2 909 932 B1

## Description

La présente invention concerne un transducteur à ondes de volume guidées en surface par des structures d'excitation synchrone de l'onde élastique guidée.

En micro-acoustique, particulièrement dans le domaine des dispositifs à ondes élastiques de surface (SAW pour Surface Acoustic Wave) et des résonateurs à ondes de volume sur films minces (FBARs pour Film Bulk Acoustic Resonator), différents matériaux piézoélectriques peuvent être utilisés, mais en pratique le choix est généralement limité par le besoin de réduire les pertes, de disposer d'un couplage électromécanique élevé (ce qui conditionne la largeur de bande de fréquence atteignable pour des applications filtres), de disposer d'une faisabilité technologique avérée et surtout, dans le cas des FBARs, compatible avec l'utilisation de plaques de silicium de qualité "microélectronique" de large diamètre (4 pouces minimum, voire 6, 8 pouces et même plus, un pouce étant égal à 25,4 mm en unités S.I.), ces dernières structures étant réalisées industriellement sur ce type de support.

En définitive, seuls quelques types de matériaux répondent à ces exigences tels que le quartz, le niobate de lithium et le tantalate de lithium pour les dispositifs à ondes de surface SAW, le nitrure d'aluminium (AlN) ou l'oxyde de zinc (ZnO) en films minces pour les dispositif de type FBAR, et peuvent être effectivement mis en oeuvre pour des applications industrielles.

Certains cristaux réputés pour leur qualité acoustique tels que le saphir, le carbone-diamant, le YAG (Yttrium-Aluminium-Garnet) n'étant pas piézoélectriques, il est très difficile de les exploiter pour améliorer notablement les qualités intrinsèques des composants passifs acousto-électriques. Leur exploitation pour ce type d'application passe presque systématiquement par une couche piézoélectrique déposée permettant l'excitation et la détection des ondes élastiques.

D'autres matériaux comme le silicium déjà évoqué plus haut et ses dérivés (SiGe), tous matériaux semi-conducteurs, doivent également être considérés ici comme des éléments incontournables avec lesquels les éléments passifs acousto-électriques doivent se marier pour offrir des fonctions intégrées encore inaccessibles par synthèse numérique. Ces fonctions sont par exemple le filtrage radiofréquence et la synthèse de signaux référence de fréquence en bande directe, particulièrement aux fréquences radio (bande S, bande C, bande X par exemple).

De plus, la compatibilité avec de tels matériaux revêt un enjeu économique critique pour le développement des solutions décrites ici. A part quelques exemples (GaN), ces matériaux semi-conducteurs ne présentent pas de propriétés piézoélectriques importantes et même dans la plupart des cas en sont totalement dépourvus.

Différentes « structures stratifiées» fondées sur l'empilement de couches ont ainsi été proposées pour combiner les avantages des substrats évoqués ci-dessus (par exemple les vitesses de propagation d'ondes élastiques très élevées du diamant ou les très faibles pertes acoustiques du saphir) et des propriétés piézoélectriques capables de répondre au cahier des charges des filtres et sources RF modernes.

Les plus efficaces, c'est-à-dire celles ayant donné lieu à une exploitation industrielle réussie, sont fondées sur l'utilisation de nitrure d'aluminium (AlN) qui répond à un grand nombre des critères énumérés ci-dessus. Les efforts déployés ces vingt dernières années pour assurer la maîtrise industrielle des propriétés physiques de ce matériau a ouvert la voie à de nouveaux principes de transducteurs, de résonateurs et de structures d'excitation et de guidage d'ondes élastiques de surface ou de volume.

Un transducteur classique dont la structure est fondée sur ces nouveaux principes comprend classiquement un substrat acoustique, non piézoélectrique et de haute qualité acoustique, c'est-à-dire ayant une vitesse de phase élevée et de faibles pertes intrinsèques, une couche piézoélectrique pleine et uniforme déposée intégralement au-dessus du substrat acoustique, des électrodes d'excitation de transduction sous forme de peignes inter-digités déposés sur la couche piézo-électrique pour les ondes élastiques de surface. D'autres formes de réalisation ont été proposées, par exemple, avec une couche métallique pleine entre le substrat acoustique et la couche piézoélectrique, pour tenter d'améliorer les caractéristiques physiques des modes engendrés. Cette structure est dénommée sous l'acronyme anglais STFM (Substrate-Metal-Film-Transducer).

Néanmoins, pour les applications des composants à ondes de surface guidées, le coefficient de couplage électromécanique correspondant obtenu reste assez modeste. Il est de trois à cinq fois celui du dioxyde de silicium cristallin ($SiO_2$ - quartz) au maximum en considérant les ondes de surface sur ce dernier matériau, les ondes de volume longitudinales suivant l'axe C du matériau étant elles quinze fois mieux couplées que les ondes de surface pour le nitrure d'aluminium. Cette caractéristique vaut pour les structures de transducteurs métalliques à doigts entrelacés ou inter-digités déposées en surface du film piézoélectrique, comparables à celles réalisées sur un substrat piézoélectrique classique en un matériau tel que le quartz, le niobate de lithium ($LiNbO_3$), et le tantalate de lithium ($LiTaO_3$).

Le document FR2938136 décrit un tel transducteur à ondes de surface guidées et plus précisément un filtre élémentaire de type à ondes de volumes à modes harmoniques élevés HBAR.

Une des raisons qui permet d'expliquer cet état de fait concerne d'une part, le déploiement des lignes de champ électrostatique dans le film, moteur de l'excitation piézoélectrique, qui ne permettent pas de tirer le meilleur parti du couplage colinéaire à l'axe C (le "moteur" du mode longitudinal habituellement exploité pour les FBARs), et d'autre part la nature des déplacements de l'onde de surface, principalement guidée par le substrat qui porte ainsi la partie principale de l'énergie acousto-électrique engendrée. Enfin le principe même de l'excitation par peignes inter-digités entraîne en partie une combinaison destructive des modes partiels composant l'onde.

L'invention présentée ici propose de remédier aux inconvénients ci-dessus et d'améliorer le coefficient de couplage électromécanique de composants à ondes de surface guidées tels que décrits ci-dessus.

A cet effet, l'invention a pour objet un transducteur à ondes de volume guidées en surface, destiné à fonctionner à une longueur d'onde acoustique de surface λ et à convertir un signal électrique à une fréquence de travail ft correspondant à la longueur d'onde acoustique λ en une onde de volume guidée en surface et réciproquement, comprenant un substrat acoustique et un plan de masse électrique,

le substrat acoustique étant réalisé sous la forme d'une plaque formant une première couche en un premier matériau électriquement isolant, monocristallin ou polycristallin coupée selon trois plans d'une première coupe cristalline définis suivant la nomenclature (YX$wlt$)/φ/θ/ψ du standard IEEE Std-176 (révision 1949) par un premier angle φ, un deuxième angle θ, et un troisième angle ψ, la plaque de substrat étant étendue selon une première épaisseur t1, une première longueur l1 et une première largeur w1, la plaque du substrat acoustique ayant une première face de repos et, en vis-à-vis dans le sens de la première épaisseur t1, une deuxième face de support opposée ayant un état de rugosité, la coupe cristalline du premier matériau étant choisie et l'état de rugosité de la deuxième face étant suffisamment lisse pour permettre la propagation d'ondes élastiques de Rayleigh ou de Bleustein-Gulyaev ou des pseudo-ondes de surface (PSAW) dans le sens de la première longueur l1 du substrat acoustique,

le plan de masse étant réalisé sous la forme d'une deuxième couche en un deuxième matériau électriquement conducteur, déposée sur le substrat acoustique du coté de sa deuxième face, la deuxième couche étant étendue selon une deuxième épaisseur uniforme t2, une deuxième largeur w2, et une deuxième longueur l2, la deuxième couche ayant une troisième face, disposée en vis à vis de la deuxième face du substrat acoustique, et ayant une quatrième face opposée et en vis-à-vis de la troisième face dans le sens de la deuxième épaisseur t2, les directions de la deuxième épaisseur t2, la deuxième largeur w2, la deuxième longueur l2 étant respectivement les mêmes que les directions de la première épaisseur t1, la première largeur w1, la première longueur l1;

caractérisé en ce que

le transducteur à ondes de volume guidées en surface comprend un réseau de sources d'excitation acoustiques synchrones, configuré pour être relié mécaniquement et électriquement à une source électrique d'excitation synchrone, déposé sur le plan de masse, et comportant un premier peigne d'un ou plusieurs transducteurs piézoélectriques élémentaires rangés selon une première direction et un deuxième peigne d'un ou plusieurs transducteurs piézoélectriques élémentaires dans le même nombre que ceux du premier peigne rangés selon une deuxième direction opposée à la première de sorte que les transducteurs piézoélectriques élémentaires du premier peigne et du deuxième peigne soient entrelacées alternativement deux à deux suivant un pas périodique p de réseau et selon la direction de propagation des ondes élastiques de surface le long de la deuxième face de support dans le sens de la première longueur l1 du substrat acoustique, le double du pas de réseau 2p étant égal sensiblement à la longueur d'onde acoustique λ;

chaque transducteur élémentaire comporte un barreau unique et différent et une électrode métallique supérieure d'excitation électrique unique et différente, le barreau étant réalisé en un troisième matériau piézoélectrique, monocristallin ou polycristallin, coupé selon trois plans d'une deuxième coupe cristalline définis suivant la nomenclature (YX$wlt$)/φ/θ/ψ du standard IEEE Std-176 (révision 1949) par un deuxième angle φ2, un deuxième angle θ2, et un troisième angle ψ2, ayant une même forme profilée de section rectangulaire ou trapézoïdale, ayant une cinquième face en vis de la face du plan de masse, une sixième face opposée à la cinquième face sur laquelle est déposée l'électrode d'excitation associée, et deux flancs latéraux reliant de part et d'autre la cinquième face et la sixième face, et définie par une troisième épaisseur h comme étant la hauteur séparant la cinquième face et la sixième face, une troisième largeur d de recouvrement du plan de masse et une troisième longueur L;

le troisième matériau et la deuxième coupe étant choisis pour permettre la propagation d'ondes élastiques de volume dans le sens de la troisième épaisseur h avec un coefficient de couplage élevé au moins supérieur ou égal à 0,1%, et

la troisième épaisseur h est comprise entre un quart et trois quarts de la longueur d'onde λ.bulk du mode élastique de volume se propageant au sein du troisième matériau dans le sens de la troisième épaisseur et correspondant à la fréquence de travail ft ;

la troisième largeur d étant strictement inférieure à la moitié de la longueur d'onde acoustique et de même orientation que la direction de propagation des ondes de volume guidées en surface du substrat acoustique ;

deux transducteurs élémentaires adjacents étant séparés entre eux dans le sens de leur troisième largeur par un espace d'écartement de longueur d'écartement D non nulle, la somme de la troisième largeur d et de la longueur d'écartement D étant égal au pas p du réseau, et le deuxième matériau est acoustiquement perméable à des ondes élastiques générées par piézoélectricité.

Suivant des modes particuliers de réalisation, le transducteur comporte l'une ou plusieurs des caractéristiques suivantes :

- le premier peigne et le deuxième peigne comprennent chacun un nombre de transducteurs élémentaires supérieur à deux, de préférence supérieur à 5 ;

- la deuxième coupe cristallographique du deuxième matériau est choisie de façon à permettre l'excitation piézoélectrique d'ondes élastiques de volume se propageant dans chaque transducteur élémentaire dans le sens de la troisième épaisseur, ces ondes étant soit des ondes de déformation essentiellement longitudinale, soit des ondes de déformation essentiellement transversale ;

- la troisième épaisseur h de chaque transducteur élémentaire est comprise soit entre 0,9 fois λbulk/2 et 1,1 fois λbulk/2 soit entre 0,9 fois λbulk/4 et 1,1 fois λbulk/4, et réglée de façon qu'un niveau de résonance maximal soit atteint dans chacun des transducteur élémentaires ;

- le premier matériau est compris dans l'ensemble formé par le saphir, le diamant, le silicium, le YAG (Yttrium Aluminium Garnet ou grenat d'yttrium et d'aluminium en français - dits grenats alumineux) et autres composés à base de grenat (grenats ferrifères ou chromifères), le quartz fondu, le quartz cristallin, le niobate de lithium, le tantalate de lithium, la langasite et ses variantes notamment la langanite et la langatate, ainsi que l'orthophosphate de gallium,

le deuxième matériau est compris dans l'ensemble formé par les métaux Al, Mo, Pt, W, Cu, Ni, Au, Ag et les alliages AlCu, AlTi, AlSi, et Ti/Pt, Ta/Pt, et

le troisième matériau est compris dans l'ensemble formé par le nitrure d'aluminium, le nitrure d'aluminium dopé au scandium, l'oxyde de zinc, le PZT, le niobate de lithium, le tantalate de lithium, le quartz cristallin, la langasite et ses variantes, l'orthophosphate de gallium, le niobate de potassium et les relaxeurs de type PMN-PT et autres variantes de cette nature ;

- le premier matériau du substrat acoustique est de préférence le quartz amorphe ou cristallisé, la langasite et ses variantes notamment la langanite et la langatate, l'orthophosphate de gallium, le tétraborate de lithium le niobate de potassium, le tantalate de lithium de façon à compenser les effets de température de dérive observés pour des ondes de volume générées par les transducteurs élémentaires et à polarisation transverse dans le sens de la troisième longueur L ;

- la longueur L de chaque transducteur élémentaire est supérieure à dix fois la longueur d'onde acoustique λ des ondes de volume guidées en surface du substrat acoustique ;

- le pas p de répétition des transducteurs est réglé en fonction d'une longueur d'onde de surface caractéristique d'une onde élastique de surface de la famille comprenant les ondes de Rayleigh, les ondes Bleustein-Gulyaev, les ondes STW, les ondes de Sezawa pour permettre l'excitation efficace des ondes de surface sur une zone de surface externe située en dehors et dans le prolongement de la région du réseau des transducteurs élémentaires ;

- soit le plan de masse, situé entre les transducteurs élémentaires adjacents est exposé, soit une couche de troisième matériau dont l'épaisseur est inférieur au quart de la troisième épaisseur h est déposée entre les transducteurs élémentaires adjacents ;

- chaque transducteur piézoélectrique élémentaire comprend une couche d'un matériau acoustique de compensation des effets de dérive de la fréquence en température, interposée soit entre le barreau piézoélectrique et le plan de masse, soit entre le barreau piézoélectrique et l'électrode supérieure d'excitation associée, le matériau de compensation en température pouvant être par exemple de la silice amorphe ;

- les barreaux ont une même forme profilée de section trapézoïdale, et dans lequel pour chaque barreau l'angle dépouille formé entre la normale de la cinquième face et une direction transverse orienté dans le même sens que la normale est inférieur à 30 degrés.

L invention a également pour objet un procédé de fabrication d'un transducteur à ondes de volume guidées en surface, destiné à fonctionner à une longueur d'onde acoustique λ et à convertir un signal électrique à une fréquence correspondant à la longueur d'onde acoustique λ en une onde de volume guidée en surface et réciproquement, comprenant les étapes consistant à dans une étape un substrat acoustique est réalisé sous la forme d'une plaque formant un première couche en un premier matériau électriquement isolant, monocristallin ou polycristallin coupée selon trois plans d'une première coupe cristalline définis suivant la nomenclature (YXwlt)/φ/θ/ψ du standard IEEE Std-176 (révision 1949) par un premier angle φ, un deuxième angle θ, et un troisième angle ψ, la plaque étant étendue selon une première épaisseur t1, une première longueur l1 et une première largeur w1, la plaque du substrat acoustique ayant une première face de repos et, en vis-à-vis dans le sens de la première épaisseur t1, une deuxième face de support opposée ayant un état de rugosité, la coupe cristalline du premier matériau étant choisie et l'état de rugosité de la deuxième face étant suffisamment lisse pour permettre la propagation d'ondes élastiques de Rayleigh ou de Bleustein-Gulyaev ou de pseudo-ondes de surface (PSAW) dans le sens de la première longueur l1 du substrat acoustique, et

dans une étape suivante un plan de masse est réalisé sous la forme d'une deuxième couche en un deuxième matériau électriquement conducteur, déposée sur le substrat acoustique du coté de sa deuxième face, la deuxième couche étant étendue selon une deuxième épaisseur uniforme t2, une deuxième largeur w2, et une deuxième longueur l2, la deuxième couche ayant une troisième face, disposée en vis à vis de la deuxième face du substrat acoustique, et ayant une quatrième face opposée et en vis-à-vis de la troisième face dans le sens de la deuxième épaisseur t2, les directions de la deuxième épaisseur t2,

la deuxième largeur w2, la deuxième longueur l2 étant respectivement les mêmes que les directions de la première épaisseur t1 , la première largeur w1, la première longueur l1, et le deuxième matériau étant acoustiquement perméable à des ondes élastiques générées par piézoélectricité;

caractérisé en ce que

le procédé comprend en outre une étape consistant en ce que

dans une étape suivante un réseau de sources d'excitation acoustique synchrone est réalisé en étant disposé sur le plan de masse, le réseau étant configuré pour être relié mécaniquement et électriquement à une source électrique d'excitation synchrone, et comportant un premier peigne d'un ou plusieurs transducteurs piézoélectriques élémentaires rangés selon une première direction et un deuxième peigne d'un ou plusieurs transducteurs piézoélectriques élémentaires dans le même nombre que ceux du premier peigne rangés selon une deuxième direction opposée à la première de sorte que les transducteurs piézoélectriques élémentaires du premier peigne et du deuxième peigne soient entrelacées alternativement deux à deux suivant un pas périodique p de réseau et selon la direction de propagation des ondes élastiques de surface le long de la deuxième face de support dans le sens de la première longueur l1 du substrat acoustique, le double du pas de réseau 2p étant égal sensiblement à la longueur d'onde acoustique $\lambda$;

chaque transducteur élémentaire comportant un barreau unique et différent et une électrode métallique supérieure d'excitation unique et différente, le barreau étant réalisé en un troisième matériau piézoélectrique, monocristallin ou polycristallin, coupé selon trois plans d'une deuxième coupe cristalline définis suivant la nomenclature (YX*wlt*)/$\varphi$/$\theta$/$\psi$ du standard IEEE Std-176 (révision IRE 1949) par un deuxième angle $\varphi2$, un deuxième angle $\theta2$, et un troisième angle $\psi2$, ayant une même forme profilée de section rectangulaire ou trapézoïdale, ayant une cinquième face en vis de la face du plan de masse, une sixième face opposée à la cinquième face sur laquelle est déposée l'électrode d'excitation associée, et deux flancs latéraux reliant de part et d'autre la cinquième face et la sixième face, et définie par une troisième épaisseur h comme la hauteur séparant la cinquième face et la sixième face, une troisième largeur d de recouvrement du plan de masse et une troisième longueur L;

le troisième matériau et la deuxième coupe étant choisis pour permettre la propagation d'ondes élastiques de volume dans le sens de la troisième épaisseur h avec un coefficient de couplage élevé au moins supérieur ou égal à 0,1%, et

la troisième épaisseur h étant comprise entre un quart et trois quarts de la longueur d'onde $\lambda$.bulk du mode élastique de volume se propageant au sein du troisième matériau dans le sens de la troisième épaisseur et correspondant à la fréquence de travail ft ;

la troisième largeur d étant strictement inférieure à la moitié de la longueur d'onde acoustique et de même orientation que la direction de propagation des ondes de volume guidées en surface du substrat acoustique ;

deux transducteurs élémentaires adjacents étant séparés entre eux dans le sens de leur troisième largeur par un espace d'écartement de longueur d'écartement D non nulle, la somme de la troisième largeur d et de la longueur d'écartement D étant égal au pas p du réseau.

L'invention a également pour objet un transducteur, excité de manière synchrone et exploitant des ondes de volume guidées en surface ayant une longueur d'onde acoustique prédéterminée, comprenant

- un transducteur défini tel que défini ci-dessus, et
- une source de tension différentielle ayant une première borne de sortie et une deuxième borne de sortie dont les polarités en tension appliquées sont inverse l'une de l'autre, la première borne de sortie étant connectée au premier peigne et la deuxième borne de sortie étant connectée au deuxième peigne.

L'invention sera mieux comprise à la lecture de la description de plusieurs modes de réalisation qui va suivre, donnée uniquement à titre d'exemple et faite en se référant aux dessins sur lesquels :

La Figure 1 est une vue en perspective de la structure d'une première forme de réalisation d'un transducteur à ondes de volume guidées en surface selon l'invention ;

La Figure 2 est une coupe du transducteur décrit à la Figure 1 selon le plan de coupe II-II;

La Figure 3 est une vue en perspective de la structure d'une deuxième forme de réalisation d'un transducteur à ondes de volume guidées selon l'invention ;

La Figure 4 est une coupe du transducteur décrit à la Figure 3 selon le plan de coupe IV-IV;

La Figure 5 est une vue d'un modèle de la structure d'une cellule élémentaire de transduction classique de l'état de la technique dans laquelle la couche piézoélectrique est pleine en termes de recouvrement du substrat acoustique et constituée de nitrure d'aluminium;

La Figure 6 est une vue d'un modèle de la structure d'une cellule de transduction de l'invention formant un transducteur élémentaire du transducteur à ondes de volume guidées en surface dans laquelle la couche piézoélectrique de recouvrement du substrat acoustique est constituée en nitrure d'aluminium, et limitée et contenue dans la portion parallélépipédique située juste en dessous de l'électrode supérieure d'excitation associée;

Les Figures 7 et 8 sont des vues des admittances harmoniques observées et correspondant respectivement aux modèles décrits dans les Figures 5 et 6 pour une épaisseur de nitrure d'aluminium égale à 2,5 µm, et correspondant aux modes de résonance attendus ;

La Figure 9 est une vue de l'admittance harmonique observée correspondant au modèle décrit dans la Figure 5 pour une épaisseur de nitrure d'aluminium égale à 5 µm, et correspondant au mode de résonance attendu,

La Figure 10 est une vue de l'admittance harmonique observée correspondant au modèle décrit dans la Figure 6 pour une épaisseur de nitrure d'aluminium égale à 5 µm, et correspondant au mode de résonance attendu ;

La Figure 11 est une vue de l'admittance harmonique observée correspondant au modèle décrit dans la Figure 6 pour une épaisseur de nitrure d'aluminium égale à 5 µm, et correspondant à un deuxième mode de résonance nouveau ;

La Figure 12 est une vue de l'évolution de la vitesse et de la réflectivité du premier mode de résonance en fonction de l'épaisseur normalisée du barreau.

La Figure 13 est un ordinogramme d'un procédé de fabrication d'un transducteur à ondes de volume guidées en surface des Figures 1 à 4 ;

La Figure 14 est vue en coupe partielle d'une variante des transducteurs des Figures 1 à 4 dans laquelle seuls deux transducteurs élémentaires sont représentés.

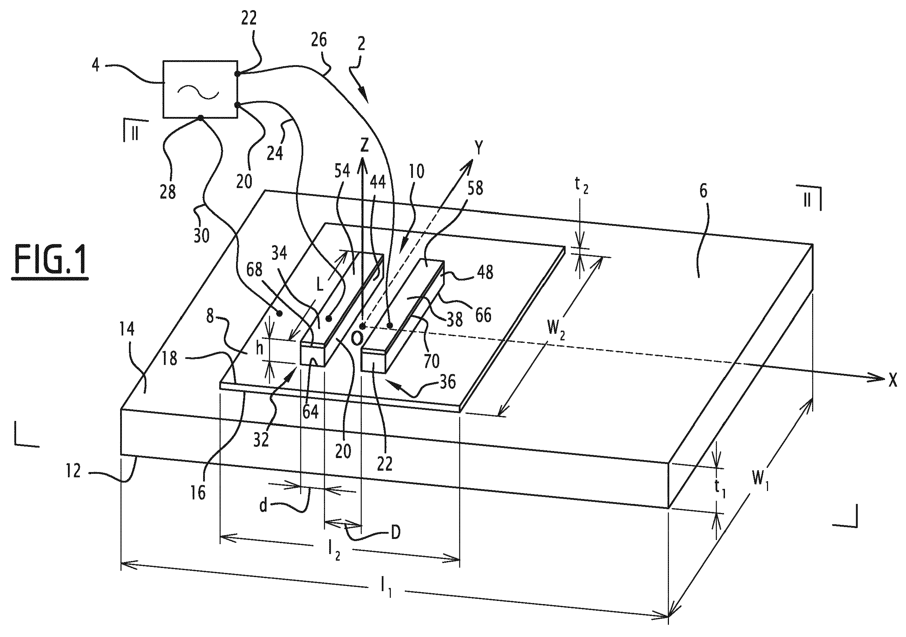

Suivant la Figure 1 et un premier mode de réalisation, un transducteur électro-acoustique 2 à ondes élastiques de volume guidées en surface, destiné à fonctionner à une longueur d'onde acoustique de surface prédéterminée λ et à convertir un signal électrique à une fréquence de travail ft correspondant à la longueur d'onde acoustique λ en une onde de volume du transducteur guidée en surface du substrat et réciproquement, est connecté à une source électrique 4 qui est configurée pour fonctionner par exemple comme une source externe d'excitation électrique générale.

En variante, la source électrique 4 est configurée pour fonctionner comme un récepteur électrique ou à la fois comme une source d'excitation électrique et un récepteur électrique.

Le transducteur électro-acoustique 2 comprend un substrat acoustique 6, un plan de masse électrique 8, et un réseau 10 de transducteurs élémentaires électroacoustiques d'excitation acoustique synchrone.

Le substrat acoustique 6 est réalisé sous la forme d'une plaque formant une première couche en un premier matériau électriquement isolant, monocristallin ou poly-cristallin, coupée selon trois plans d'une première coupe cristalline définis suivant la nomenclature (YXwlt)/φ/θ/ψ du standard IEEE Std-176 (révision IRE-1949) par un premier angle φ1, un deuxième angle θ1, et un troisième angle ψ1.

La plaque acoustique 6 de forme parallélépipédique est étendue selon une première épaisseur t1, une première longueur l1 et une première largeur w1. La plaque 6 a une première face de repos 12 et, en vis-à-vis dans le sens de la première épaisseur t1, une deuxième face de support opposée 14 ayant un état de rugosité, la coupe cristalline du premier matériau étant choisie et l'état de rugosité de la deuxième face étant suffisamment lisse pour permettre la propagation d'ondes élastiques de Rayleigh ou de Bleustein-Gulyaev ou de pseudo-ondes de surface (PSAW) dans le sens de la première longueur l1 du substrat acoustique 6.

Le plan de masse électrique 8 est réalisé sous la forme d'une deuxième couche d'un deuxième matériau électriquement conducteur. La deuxième couche est déposée sur le substrat acoustique 6 du coté de sa deuxième face 14. La deuxième couche 8 est étendue selon une deuxième épaisseur uniforme t2, une deuxième largeur w2, et une deuxième longueur l2. La deuxième couche 8 a une troisième face 16, disposée en vis à vis de la deuxième face 14 du substrat acoustique 6, et a une quatrième face 18, opposée et en vis-à-vis de la troisième face 16 dans le sens de la deuxième épaisseur t2, les directions de la deuxième épaisseur e2, la deuxième largeur w2, la deuxième longueur l2 étant respectivement les mêmes que les directions de la première épaisseur e1, la première largeur w1, la deuxième longueur l2.

Le réseau 10 de transducteurs élémentaires d'excitation acoustique synchrone et de guidage acoustique des ondes de volume et de surface est ici relié mécaniquement et électriquement à la source électrique d'excitation synchrone 4 en une première borne d'entrée 20 et une deuxième borne d'entrée 22 de polarités opposées au travers d'un premier fil conducteur 24 et d'un deuxième fil conducteur 26 correspondants. Le plan de masse 8 est ici relié mécaniquement et électriquement à la source électrique d'excitation 4 en une troisième borne d'entrée 28 de mise à une masse électrique commune en entrée 22 au travers d'un troisième fil conducteur 30.

Il est à remarquer que lorsque la source électrique d'excitation 4 en tension est différentielle, il n'est pas nécessaire de connecter le plan de masse 8 à la masse de source électrique d'excitation 4.

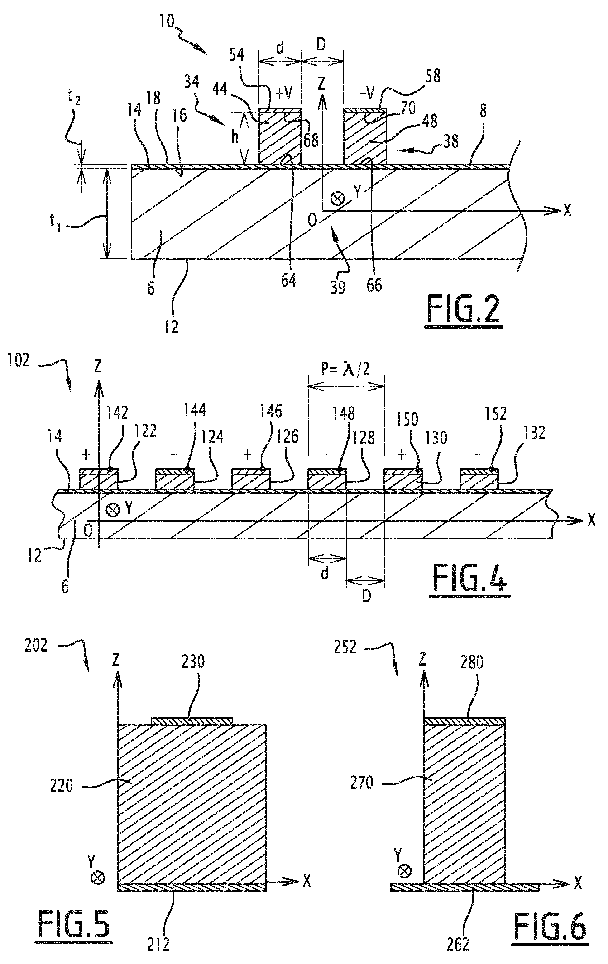

Suivant les Figures 1 et 2, le réseau 10 comporte un premier peigne 32, formé ici d'un unique transducteur piézoélectrique élémentaire 34 agencé selon une première direction, et un deuxième peigne 36, formé ici d'un unique transducteur piézoélectrique élémentaire 38, de même forme que le transducteur piézoélectrique élémentaire 34 du premier peigne 32.

Le transducteur piézoélectrique élémentaire 38 du deuxième peigne 34 est agencé selon une deuxième direction opposée à la première de sorte que les transducteurs piézoélectriques élémentaires 34, 38 du premier peigne 32 et du deuxième peigne 36 sont entrelacés alternativement deux à deux suivant un pas périodique p de réseau et selon la direction de propagation des ondes acoustiques de surface le long de la deuxième face de support 14 dans le sens de la première longueur l1 du substrat acoustique 6 représentée par la direction d'un axe X allant de gauche à droite sur les Figures 1 et 2, l'axe X formant le premier axe d'un repère 39.

Le repère 39 comprend un point d'origine désigné par O, le premier axe X, un deuxième axe Y et un troisième axe Z.

L'origine O est un point du substrat acoustique 6 situé en dessous de la deuxième face 14 dans un plan médian situé à égale distance entre les deux transducteurs piézoélectriques 32, 36.

Le troisième axe Z est l'axe passant par O orienté selon la normale de la deuxième face 14 du substrat acoustique 6, et définit avec le premier axe X le plan sagittal de la Figure 2, c'est-à-dire le plan de coupe II-II de la Figure 1.

Le deuxième axe Y est l'axe du repère 39 qui rend direct le trièdre (X, Y, Z). Traversant le point O, il est représenté de bout sur la Figure 2 en fuyant vers l'arrière.

Le pas de réseau p est sensiblement égal à la moitié de la longueur d'onde acoustique $\lambda$ de l'onde de volume guidée en surface le long du substrat acoustique ou, de manière équivalente, le double du pas de réseau 2p est sensiblement égal à la longueur d'onde acoustique $\lambda$ de l'onde de volume guidée en surface du substrat acoustique.

Chaque transducteur élémentaire 34, 38 comporte un barreau unique et différent 44, 48 et une électrode métallique supérieure d'excitation électrique, unique et différente 54,58.

Chaque barreau 44, 48 est réalisé en un troisième matériau piézoélectrique, monocristallin ou polycristallin, coupé selon trois plans d'une deuxième coupe cristalline définis suivant la nomenclature (YXwlt)/$\varphi$/$\theta$/$\psi$ du standard IEEE Std-176 (révision IRE-1949) par un deuxième angle $\varphi$2, un deuxième angle $\theta$2, et un troisième angle $\psi$2.

Chaque barreau 44, 48 a une même forme parallélépipédique définie par une troisième épaisseur h, une troisième largeur d, et une troisième longueur L, et a respectivement une cinquième face 64, 66 en vis de la face 18 du plan de masse 8 et une sixième face 68, 70, opposée à la cinquième face 64, 66, sur laquelle est déposée l'électrode supérieure d'excitation 54, 58 associée.

Le troisième matériau et la deuxième coupe sont choisis pour permettre la propagation d'ondes acoustiques de volume dans le sens de la troisième épaisseur h avec un coefficient de couplage électromécanique élevé au moins supérieur ou égal à 0,1%.

En pratique le coefficient de couplage électromécanique minimum dépend de l'application.

Ainsi, la valeur minimale du coefficient électromécanique est égale à 5% dans le cas d'applications à des filtres, est compris entre 0,1 et 1% dans le cas d'applications à des résonateurs pour source de fréquence stable de haute pureté spectrale. Dans le cas à des applications à des capteurs, cette valeur minimale peut être définie entre 0,1% et plusieurs dizaines de pour-cent en fonction de la nature des matériaux mis en oeuvre et de l'application visée.

En pratique, le coefficient de couplage électromécanique atteignable dépend du matériau mis en oeuvre. Pour le nitrure d'aluminium (AIN) et l'oxyde de zinc (ZnO) en mode longitudinal selon l'axe cristallographique dit axe C (aussi appelé axe optique), une valeur généralement admise est d'un minimum de 5%, pouvant atteindre les 8% pour le dernier. Pour le niobate de lithium sous forme de matériau reporté, aminci puis usiné afin de présenter la structure recherchée, le couplage est compris entre 15 et 20% pour les coupes au voisinage de l'orientation (YX*l*)/36° (mode longitudinal) et supérieur à 40% pour les coupes avoisinant les orientations (XY), (XZ) et (YX*l*)/165° (mode de cisaillement d'épaisseur).

La même troisième épaisseur h de chaque barreau 44, 48 est comprise entre un quart et trois quarts de la longueur d'onde $\lambda$bulk du mode élastique de volume se propageant au sein du troisième matériau dans le sens de la troisième épaisseur h et correspondant à la fréquence de travail ft.

La troisième largeur d est strictement inférieure à la moitié de la longueur d'onde acoustique de surface, la longueur d'onde de surface étant plus globalement inférieure à la longueur d'onde de l'onde de volume rampante (SSBW) de plus petite vitesse selon la même direction de propagation. Elle possède la même orientation que la direction de propagation des ondes de volume guidées en surface du substrat acoustique 6.

La longueur d'onde de surface acoustique admissible est liée aux propriétés physiques du substrat et l'onde de surface acoustique admissible peut être forcée par l'excitation du réseau des transducteurs élémentaires de volume à des vitesses de propagation potentiellement supérieures à celle de l'onde « naturelle » de la surface (c'est-à-dire l'onde de surface naturelle dans laquelle la surface du substrat est libre) si et seulement si cette longueur d'onde ne correspond pas à la condition de décrochement du mode pour laquelle le guidage par la surface devient partiel.

Dans tout ce qui suit le terme « onde acoustique de surface » désignera globalement une onde de surface « naturelle » ou une onde de surface « forcée » par le réseau d'excitation et dont la longueur d'onde est inférieure à la longueur d'onde de l'onde de volume rampante (SSBW) de plus petite vitesse selon la direction de propagation.

Les deux transducteurs élémentaires 32, 36 d'excitation acoustique sont adjacents, rangés côte à côte dans le sens de la longueur l1 du substrat, et séparés entre eux dans le sens de leur troisième largeur d par un espace d'écartement de longueur d'écartement D non nulle, la somme de la troisième largeur d et de la longueur d'écartement D étant égale au pas p du réseau 10.

Le deuxième matériau électriquement conducteur du plan de masse 8 est acoustiquement perméable aux ondes élastiques générées par piézoélectricité par les deux transducteurs élémentaires 34, 38 d'excitation acoustique.

Ainsi, dans la structure proposée des Figures 1 et 2, le troisième matériau piézoélectrique servant à la transduction et disposé entre les électrodes d'excitation et le plan de masse 8 est situé seulement sous les électrodes supérieures 54, 58 d'excitation électrique à l'aplomb de ces dernières, mais pas entre elles. Une telle structure peut être obtenue, par exemple, en gravant une couche piézoélectrique de troisième matériau, préalablement déposée de manière uniforme sur le plan de masse 8, par enlèvement du troisième matériau situé entre les électrodes supérieures 54, 58. Les électrodes supérieures peuvent le cas échéant servir de masque de gravure.

Ainsi, la solution proposée améliore la configuration des lignes de champ en structurant le film piézoélectrique de transduction de sorte que le troisième matériau piézoélectrique soit localisé strictement sous les électrodes de surface, d'autre part en plaçant la contre-électrode formant le plan de masse 8 sous le film piézoélectrique, ici discontinue et lacunaire et en la portant à la masse électrique en tant que référence électrique pour conditionner au mieux les lignes de champ électriques entre les électrodes d'excitation.

En fonctionnement, la source électrique 4 est ici une source différentielle de tension d'excitation électrique alternative, par exemple de forme d'onde sinusoïdale. Le plan de masse conducteur 8 est porté à la référence électrique de masse et sert ainsi de référence de phase d'excitation.

La tension délivrée par la source électrique 4 en opposition de phase entre ses bornes de sortie 20, 22 excite en opposition de phase la paire des transducteurs électroacoustiques élémentaires adjacents 34, 38.

Sur la Figure 2, la tension à un instant donné étant fixée à +V sur l'électrode 54 du transducteur élémentaire 34 du premier peigne, la tension fixée sur l'électrode 58 du transducteur élémentaire 38 du deuxième peigne 36 est inverse et égale à -V.

Le signal V oscille en fonction du temps à la fréquence ft.

Chaque résonateur, formé par un transducteur élémentaire unique et différent 34, 38, son électrode supérieure associée 54, 58, et la partie du plan de masse 8 située à l'aplomb de l'électrode supérieure 54, 58, rayonne indépendamment une certaine énergie acoustique dans le substrat acoustique 6.

Cependant, en raison de la phase opposée des ondes élastiques rayonnées et de la distance entre les sources acoustiques ainsi constituées, inférieure ou égale à une demi-longueur d'onde λ de l'onde de surface du substrat 6, le rayonnement global de la surface vers le volume, c'est-à-dire en sens inverse de l'axe Z, est presque totalement supprimé par interférences destructives des ondes élastiques rayonnées par les deux sources.

L'énergie est ainsi confinée en surface et peut se propager le long de la surface sur une certaine distance. Les calculs d'admittance harmonique montrent que les pertes associées à la propagation du mode sous le réseau sont négligeables par rapport aux pertes intrinsèques (pertes acoustiques par effet visco-élastique, pertes diélectriques) des matériaux mis en jeu. En effet, pour les modes guidés sous le réseau, le calcul de ces pertes indique des valeurs notablement inférieures à 0,5 mdB ($0,5 \times 10^{-3}$ dB) par longueur d'onde acoustique de l'onde de surface, soit beaucoup moins que les pertes induites par le rayonnement d'une onde à polarisation elliptique dans le milieu adjacent si celui-ci est de l'air (rayonnement de la composante normale à la surface, quasi-nul dans le cas des ondes de cisaillement et totalement éliminé par encapsulation sous vide du composant).

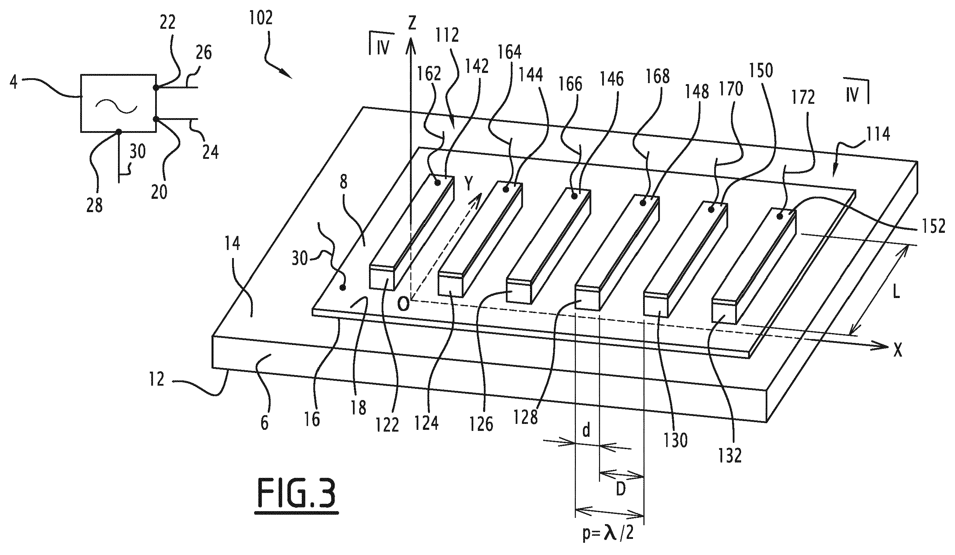

Suivant la Figure 3 et un deuxième mode de réalisation, un transducteur électro-acoustique 102 à ondes élastiques de volume guidées en surface, destiné à fonctionner à une longueur d'onde acoustique prédéterminée λ, est connecté à l'instar du transducteur 2 décrit aux Figures 1 et 2 à la même source électrique 4, configurée pour fonctionner par exemple ici comme une source externe d'excitation électrique générale.

Le transducteur électro-acoustique 102 comprend à l'instar du transducteur 2 le même substrat acoustique 6, le même plan de masse électrique 8, et un réseau 110 de transducteurs élémentaires électroacoustiques d'excitation acoustique synchrone.

Le réseau 110 de transducteurs élémentaires d'excitation synchrone et de guidage des ondes de volume élastiques en surface est ici relié mécaniquement et électriquement à la source électrique 4 en la première borne d'entrée 20 et la deuxième borne d'entrée 22 de polarités opposées au travers du premier fil conducteur 24 et du deuxième fil conducteur 26 correspondants. Le plan de masse 8 est ici relié mécaniquement et électriquement à la source électrique d'excitation 4 en la troisième borne d'entrée 28 de mise à une masse électrique commune de la source 4 au travers du troisième fil conducteur 30.

Suivant les Figures 3 et 4, le réseau 110 comporte un premier peigne 112 et un deuxième peigne 114 de plusieurs transducteurs piézoélectriques élémentaires 122, 124, 126, 128, 130, 132.

Le premier peigne 112 est ici formé de trois premiers transducteurs piézoélectriques élémentaires, désignés respectivement par les références 122, 126, 130, et agencés selon une même première direction orientée.

Le deuxième peigne 114 est ici formé de trois deuxièmes transducteurs piézoélectriques élémentaires, désignés respectivement par les références 124, 128, 132, et de même forme que les premiers transducteurs piézoélectriques élémentaires 122, 126, 130 du premier peigne 112.

Les deuxièmes transducteurs piézoélectriques élémentaires 124, 128, 132 du deuxième peigne sont agencés selon une deuxième direction opposée à la première direction de sorte que les premiers transducteurs piézoélectriques élémentaires 122, 126, 130 du premier peigne 112 et les deuxièmes transducteurs piézoélectriques élémentaires 124, 128, 132 du deuxième peigne 36 sont entrelacés alternativement deux à deux suivant un pas périodique p de réseau et selon la direction de propagation des ondes élastiques de surface le long de la deuxième face de support 14 dans le sens de la première longueur l1 du substrat acoustique 6 représenté par la direction d'un axe X allant de gauche à droite sur les Figures 3 et 4, l'axe X formant le premier axe d'un repère 139.

Le repère 139 comprend un point d'origine désigné par O, le premier axe X, un deuxième axe Y et un troisième axe Z.

L'origine O est un point du substrat acoustique 6 situé en dessous de la deuxième face 14 du substrat acoustique 6 dans un plan médian traversant le premier transducteur élémentaire 122 dans sa longueur L normal au plan de la Figure 4, c'est-à-dire le plan de coupe IV-IV de la Figure 3.

Le troisième axe Z est l'axe passant par O, orienté selon la normale de la deuxième face 14 du substrat acoustique, 6 et définit avec le premier axe X le plan sagittal de la Figure 4, c'est-à-dire le plan de coupe IV-IV de la Figure 3.

Le deuxième axe Y est l'axe du repère 39 qui rend direct le trièdre (X, Y, Z). Traversant le point O, il est représenté de bout sur la Figure 4 en fuyant vers l'arrière.

Le pas de réseau p est sensiblement égal à la moitié de la longueur d'onde acoustique λ de l'onde de volume guidée en surface le long du substrat acoustique 6 ou, de manière équivalente, le double du pas de réseau 2p est sensiblement égal à la longueur d'onde acoustique λ de l'onde de volume guidée en surface du substrat acoustique.

Chaque transducteur élémentaire 122, 124, 126, 128, 130, 132 comporte à l'instar des transducteurs élémentaires 34, 38 du réseau 10 décrits dans les Figures 1 et 2, un barreau unique et différent et une électrode métallique supérieure 142, 144, 146, 148, 150, 152 d'excitation unique et différente, de même structure, de même troisième matériau et de même forme géométrique, c'est à dire de même troisième épaisseur $\underline{h}$, de même troisième largeur $\underline{d}$, et de même troisième longueur L.

Les électrodes supérieures 142, 146, 150 des transducteurs élémentaires 122, 126, 130 du premier peigne 112 sont reliés à la première borne 20 de la source électrique 4 au travers des liaisons électriques 162, 166, 170 mises en commun par le conducteur électrique 24.

Les électrodes supérieures 144, 148, 152 des transducteurs élémentaires 124, 128, 133 du deuxième peigne 114 sont reliés à la deuxième borne 24 de la source électrique 4 au travers des liaisons électriques 164, 168 172 mises en commun par le conducteur électrique 26, la polarité électrique de la deuxième borne 24 étant inverse de celle de la première borne.

A l'instar des transducteurs élémentaires 34, 38 du réseau 10, le troisième matériau et la deuxième coupe sont choisis pour permettre la propagation d'ondes élastiques de volume dans le sens de la troisième épaisseur h avec un coefficient de couplage électromécanique élevé au moins supérieur ou égal à 0,1%.

En pratique, la valeur minimale du coefficient électromécanique est égale à 5% dans le cas d'applications à des filtres, est compris entre 0,1 et 1% dans le cas d'applications à des résonateurs pour source de fréquence stable de haute pureté spectrale. Dans le cas à des applications à des capteurs, cette valeur minimale peut être définie entre 0,1% et plusieurs dizaines de pourcent en fonction de la nature des matériaux mis en oeuvre et de l'application visée.

La même troisième épaisseur $\underline{h}$ de chaque barreau est comprise entre un quart et 1,1 fois la moitié de la longueur d'onde λbulk du mode élastique de volume se propageant au sein du troisième matériau dans le sens de la troisième épaisseur h et correspondant à la fréquence de travail ft.

La troisième largeur $\underline{d}$ est strictement inférieure à la moitié de la longueur d'onde acoustique de surface et possède la même orientation que la direction de propagation des ondes de volume guidées en surface du substrat acoustique 6.

Les deux transducteurs élémentaires 32, 36 sont adjacents et séparés entre eux dans le sens de leur troisième largeur $\underline{d}$ par un espace d'écartement de longueur d'écartement D non nulle, la somme de la troisième largeur $\underline{d}$ et de la longueur d'écartement D étant égale au pas p du réseau.

Dans le deuxième mode de réalisation, en associant plusieurs transducteurs piézoélectriques élémentaires de façon périodique et en alternant la phase de leur excitation électrique, et en plaçant l'électrode formant le plan de masse 8 sur la surface supérieure du substrat acoustique 6 et en commun en dessous des sources acoustiques locales à ondes de volume, on se rapproche alors d'une structure d'excitation d'ondes de surface.

Le transducteur peut ainsi être assimilé à un ensemble SAW de deux peignes interdigités à la différence près que le matériau piézoélectrique est strictement localisé et concentré sous les électrodes supérieures d'excitation.

Comme l'épaisseur h du troisième matériau piézoélectrique a été choisie de sorte que la fréquence de résonance de chacun de ces transducteurs élémentaires 122, 124, 126, 128, 130, 132 a priori identiques par construction, soit inférieure à la fréquence de synchronisme de l'ensemble transducteur 102 pour laquelle une onde est émise dans le substrat acoustique 6, communément appelée onde SSBW (Surface Skimming Bulk Wave que l'on peut traduire par onde de surface rampante), et à partir de laquelle la surface ne peut plus se comporter comme un guide, on constitue alors une structure dont le comportement modal permet de définir au moins deux régimes particuliers de fonctionnement.

Ces régimes de fonctionnement sont directement liés à l'épaisseur de la couche piézoélectrique et à la correspondance entre la résonance de volume et le mode de surface en termes de fréquences de résonance et de synchronisme. Un premier régime correspond à des ondes présentant une vitesse de phase faible par rapport à celle de l'onde de surface « naturelle » du substrat acoustique. Nous sommes alors à des épaisseurs de couche piézoélectrique proches d'un quart de longueur d'onde de la propagation de surface. Le régime préféré, celui donnant lieu aux coefficients de couplage les plus élevés, correspond à des couches d'épaisseur proche de la demi-longueur d'onde de la propagation de surface et de la résonance de volume. Notons que dans tous les cas, cette épaisseur est optimisée et le substrat acoustique est choisi afin que la vitesse de phase de la propagation de surface ne soit pas supérieure à la vitesse SSBW définie plus haut, ceci afin que le substrat assure bien le rôle de guide d'onde.

Les ondes élastiques sont localisées dans le substrat près de la surface et représentent un mode de surface. Selon l'orientation de couche piézoélectrique, le déplacement mécanique dans les résonateurs peut être orienté dans le plan sagittal (XOZ), ou le long de l'axe OY (les ondes transversales) ou présenter les 3 composantes (ondes de Rayleigh généralisées, dites également ondes de Sezawa).

Dans la mise en oeuvre préférée et discutée ici, nous supposons que l'oscillation principale dans les résonateurs possède une polarisation verticale (onde de compression le long de OZ). De telles vibrations exercent une contrainte appliquée au substrat $\sigma_{ZZ}$ et couplent des ondes dans le substrat avec une polarisation de déplacement semblable à celle des ondes de Rayleigh.

En fonctionnement, la source électrique 4 est ici une source différentielle de tension d'excitation électrique alternative, par exemple de forme d'onde sinusoïdale. Le plan de masse conducteur 8 est porté à la référence électrique de masse et sert ainsi de référence de phase d'excitation.

La tension délivrée par la source électrique 4 en opposition de phase entre ses bornes de sortie 20, 22 excite en opposition de phase les transducteurs élémentaires 122, 126, 130 du premier peigne 112 et les transducteurs élémentaires 124, 128, 132 du deuxième peigne 114.

Sur la Figure 4, la tension à un instant donné étant fixée à +V sur les électrodes 142, 146, 150 des transducteurs élémentaires 122, 126, 130 du premier peigne 112, la tension fixée sur les électrodes 144, 148, 152 des transducteurs élémentaires 124, 128, 132 du deuxième peigne 114 est inverse et égale à -V.

Le signal V oscille en fonction du temps à la fréquence ft.

Chaque paire de résonateurs, formée par une paire des transducteurs élémentaires (122, 124), (126, 128), (130, 132) unique et différente, une paire d'électrodes supérieures associée, et la partie du plan de masse 8 située à l'aplomb de l'électrode supérieure, rayonne indépendamment une certaine énergie acoustique dans le substrat 6.

Cependant, en raison de la phase opposée des ondes élastiques rayonnées et de la distance entre les sources acoustiques d'une même paire de résonateurs ainsi constituées, inférieure ou égale à une demi-longueur d'onde λ de l'onde de surface du substrat, le rayonnement global de la surface vers le volume, c'est-à-dire en sens inverse de l'axe Z, est presque totalement supprimé par interférences destructives des ondes élastiques rayonnées par les deux sources d'une même paire de résonateurs.

L'énergie est ainsi confinée en surface et peut se propager le long de la surface du substrat sous la forme d'ondes de volume se propageant au sein des transducteurs élémentaires constitués en réseau comme décrit plus haut et guidées en surface. Les ondes de volume guidées en surface sont d'autant plus guidées et entretenues que le nombre de paires de transducteurs élémentaires est grand.

Ainsi, le couplage acoustique entre le mode de surface et une résonance localisée dans les barreaux transducteurs et le couplage électroacoustique du transducteur 102 de la Figure 3 est plus grand que ceux présentés par le transducteur de la Figure 1.

De manière générale, le réseau comprend au moins deux transducteurs piézoélectriques arrangés sous la forme de deux peignes imbriqués, et chaque peigne parmi le premier peigne et le deuxième peigne comprend un même nombre de transducteurs élémentaires.

De manière préférée, la deuxième coupe cristallographique du troisième matériau est choisie de façon à permettre l'excitation piézoélectrique d'ondes élastiques de volume se propageant dans chaque transducteur élémentaire dans le sens de la troisième épaisseur h, ces ondes étant soit des ondes de déformation essentiellement longitudinale, soit des ondes de déformation essentiellement transversale.

Les deux modes de réalisation décrits ci-dessus permettent de combiner les avantages des composants à ondes de volume (fort couplage, haute vitesse de propagation, haute tenue à la puissance) sans être obligé de réaliser des structures fragiles comme les FBAR par exemple ou de minces films auto-suspendus, ou de déposer des couches minces de propriétés acoustiques permettant la composition d'un miroir de Bragg.

Toutefois, ce principe de dépôt de couches minces ayant les propriétés acoustiques idoines pour composer un miroir de Bragg pourrait être exploitée avec les structures de l'invention pour permettre en particulier des couplages électromécaniques maximums, compatibles avec les spécifications de filtres radiofréquences modernes, et pour permettre des vitesses de propagation effectives notablement élevées en exploitant des régimes harmoniques d'ordre élevé du miroir (voir par exemple le brevet FR 2882205-B1, 2007-06-22 ayant pour titre « Dispositif à ondes acoustiques haute fréquence »).

De manière préférée, la troisième épaisseur h de chaque transducteur élémentaire est comprise soit entre 0,9 fois λbulk/2 et 1,1 fois λbulk/2 soit entre 0,9 fois λbulk/4 et 1,1 fois λbulk p/4, et réglée de façon qu'un niveau de résonance maximal soit atteint dans chacun des transducteurs élémentaires.

De manière préférée, le premier matériau est compris dans l'ensemble formé par le saphir, le diamant, le silicium, le YAG (Yttrium Aluminium Garnet ou grenat d'yttrium et d'aluminium en français - dits grenats alumineux) et autres composés à base de grenats (grenats ferrifères ou chromifères), le quartz fondu, le quartz cristallin, le niobate de lithium, le tantalate de lithium, la langasite et ses variantes notamment la langanite et la langatate, ainsi que l'orthophosphate de gallium.

De manière préférée, le deuxième matériau est compris dans l'ensemble formé par les métaux Al, Mo, Pt, W, Cu, Ni, Au, Ag et les alliages AlCu, AlTi, AlSi, et Ti/Pt, Ta/Pt, et le troisième matériau est compris dans l'ensemble formé par le nitrure d'aluminium, le nitrure d'aluminium dopé au scandium, l'oxyde de zinc, le PZT, le niobate de lithium, le tantalate de lithium, le quartz cristallin, la langasite et ses variantes, l'orthophosphate de gallium, le niobate de potassium et les relaxeurs de type PMN-PT et autres variantes de cette nature.

En variante, le premier matériau du substrat est de préférence le quartz (amorphe ou cristallin), la langasite et ses variantes notamment la langanite et la langatate, l'orthophosphate de gallium de façon à compenser les effets de dérive de fréquence due à la température observés pour des ondes de volume générées par les transducteurs élémentaires et à polarisation transverse dans le sens de la troisième longueur L.

De manière préférée, la longueur L de chaque transducteur élémentaire est supérieure à dix fois la longueur d'onde acoustique λ des ondes de volume guidées en surface du substrat acoustique.

De manière préférée, le pas de répétition p des transducteurs est réglé en fonction d'une longueur d'onde de surface caractéristique d'une onde élastique de surface de la famille comprenant les ondes de Rayleigh, les ondes Bleustein-Gulyaev (cisaillement transverse pur), les ondes STW, les ondes de Sezawa, pour permettre l'excitation efficace des ondes de surface sur une zone de surface externe située en dehors et dans le prolongement de la région du réseau des transducteurs élémentaires.

De manière préférée, le film de matériau piézoélectrique est de préférence gravé jusqu'à la couche de métal sous-jacente, formant le plan de masse et sur laquelle ledit matériau a été déposé.

De manière préférée, les largeurs des électrodes supérieures et des barreaux coïncident exactement, cette configuration étant a priori la plus simple à mettre en oeuvre d'un point de vue technologique.

En variante, chaque électrode supérieure elle-même structurée peut présenter une largeur plus petite que celle de son barreau associé.

En variante, la source électrique 4 est configurée pour fonctionner comme un récepteur électrique ou à la fois comme une source d'excitation électrique générale et un récepteur électrique.

Dans ce qui suit et à titre d'exemple, des résultats de performances simulées d'un transducteur ayant la structure décrite aux Figures 3 et 4 sont présentés.

Dans l'outil de simulation utilisé pour obtenir ces résultats, les électrodes sont supposées réalisées en aluminium, le matériau de transduction électroacoustique est supposé en nitrure d'aluminium, et le substrat acoustique est supposé en silicium ou en saphir.

En prenant pour estimation de la vitesse de l'onde de Rayleigh dans le silicium et le saphir, $V_{SAW} \sim 5000$ m.s$^{-1}$, et la vitesse des ondes longitudinales dans le nitrure d'aluminium AlN, $V_{AlN} \sim 11000 (\pm 500)$ m.s$^{-1}$, pour une fréquence de résonance de travail ft égale à 1 GHz, les paramètres suivants permettent de favoriser l'interaction entre le mode de surface du substrat et une résonance localisée dans les barreaux des transducteurs élémentaires, considérés comme des résonateurs simples arrangés selon une structure périodique :

- la période p du réseau est égale à la moitié de la longueur d'onde λ, c'est-à-dire 2,5 μm, avec

$$\lambda = \frac{Vsaw}{ft}$$

- l'épaisseur de métal des électrodes en aluminium est comprise entre 1000 - 2000 Å (non critique ici)
- l'épaisseur h de la couche de nitrure d'aluminium est proche de λbulk/4, c'est-à-dire de 2,5μm, ou de λbulk/2, c'est-à-dire de 5,0 μm, avec

$$\lambda_{bulk} = \frac{V_{AlN}}{ft} .$$

Un premier cas et un deuxième cas ont été simulés pour comparer les performances d'un transducteur classique dans lequel la couche de transduction est pleine, uniforme et dépourvue d'évidement au dessus du substrat acoustique et les performances d'un transducteur selon l'invention décrit à la Figure 3 dans lequel la couche de transduction est un ensemble de barreaux, chaque barreau étant situé en dessous d'une électrode unique et différente.

Le premier cas est le cas dans lequel la hauteur h̲ de la couche de nitrure d'aluminium est proche de λbulk/4, c'est-à-dire de 2,5μm.

Le deuxième cas est le cas dans lequel la hauteur h̲ de la couche de nitrure d'aluminium est proche de λbulk/2, c'est-à-dire de 5μm.

Comme les impédances acoustiques du nitrure d'aluminium et du saphir sont à peu près du même ordre, on peut supposer qu'une épaisseur de nitrure d'aluminium égale à environ λbulk/2 est plus efficace pour exciter les ondes de volume que tout autre épaisseur, c'est-à-dire possède un facteur de couplage électromécanique proche de celui d'un film uniforme auto-suspendu de nitrure d'aluminium pour l'excitation d'ondes de volume.

La tension appliquée sur le réseau d'électrodes est symétrique et respecte la période de la structure (la condition de Bragg), ce qui signifie que l'électrode pleine d'aluminium formant le plan de masse déposé sur le substrat acoustique et sur laquelle les barreaux piézoélectriques sont réalisés est raccordée à un potentiel de référence (0 Volt) et une alternance de phase est appliquée sur les électrodes supérieures d'excitation tout au long de la structure.

La Figure 5 illustre le modèle de l'architecture d'une cellule élémentaire 202 de transducteur classique composée d'une électrode de fond 212 formant le plan de masse, de la couche pleine 220 de nitrure d'aluminium, et d'une électrode supérieure d'excitation 230. Cette cellule élémentaire 202 est supposée répétée à l'infini dans la structure périodique formant le transducteur classique.

La couche formant l'électrode de fond 212, réalisée en aluminium et épaisse de 100nm, est déposée sur le substrat acoustique sous-jacent, non représenté sur la Figure 5 et simulé par éléments de frontière.

L'électrode supérieure d'excitation 230 est de même épaisseur et de même nature que l'électrode de fond 212.

La couche de nitrure d'aluminium 220 est orientée avec son axe C normal au plan de propagation, le rayonnement dans le Silicium ou le Saphir s'effectuant au travers de la face arrière de l'électrode de fond vers le bas de la Figure 5, les bords latéraux de la maille étant soumis aux conditions aux limites périodiques.

Ces conditions aux limites périodiques sont obtenues en établissant formellement par le biais d'équations la périodicité spatiale du réseau grâce à une représentation, dite de Floquet, desdites conditions aux limites périodiques par une série de Fourier à laquelle est rajoutée la fonction dite de Bloch rendant compte des accords de phase compatibles desdites conditions de périodicité spatiales. Ces conditions aux limites périodiques sont également prises en compte au niveau des éléments de frontière via une forme périodique de la fonction de Green (réponse impulsionnelle acousto-électrique du substrat). Ce modèle donne entre autres accès aux admittance et impédance harmoniques des transducteurs ainsi simulés dont on extrait des paramètres clés de leur fonctionnement (vitesse de phase, effets de diffraction sous réseau, couplage électromécanique des modes, pertes de propagations, etc). En particulier, les modes se propageant à la condition de Bragg sont caractérisés par une fréquence d'entrée et une fréquence de sortie de la bande d'arrêt propre à tout mode satisfaisant de telles conditions qui, une fois déterminées, permettent de caractériser les effets de diffraction (coefficient de réflexion des ondes sur la période simulée par exemple). Une description formelle de ce modèle peut être consultée dans l'article intitulé «Composants acoustiques utilisés pour le filtrage - Modèles et outils de simulation » de Sylvain BALLANDRAS et William STEICHEN, publié dans les Techniques de l'Ingénieur, Référence E2001, 10 novembre 2010.

La Figure 6 illustre le modèle de l'architecture d'une cellule élémentaire 252 du transducteur de l'invention de la Figure 3 composée d'une électrode de fond 262 formant le plan de masse, du barreau de transduction élémentaire 270 en nitrure d'aluminium, et d'une électrode supérieure d'excitation 280. Cette cellule élémentaire 252 est supposée répétée à l'infini dans la structure périodique formant le transducteur de l'invention de la Figure 3.

La couche formant l'électrode de fond 262, réalisée en aluminium et épaisse de 100nm, est déposée sur le substrat acoustique sous-jacent, non représenté sur la Figure 6 et simulé par éléments de frontière.

L'électrode supérieure d'excitation 280 est de même épaisseur et de même nature que l'électrode de fond 262.

Le barreau de nitrure d'aluminium 270 est orientée avec son axe C normal au plan de propagation, le rayonnement dans le Silicium ou le Saphir s'effectuant au travers la face arrière de l'électrode de fond vers le bas de la Figure 6, les bords latéraux de la maille étant soumis aux conditions aux limites périodiques décrites ci-dessus.

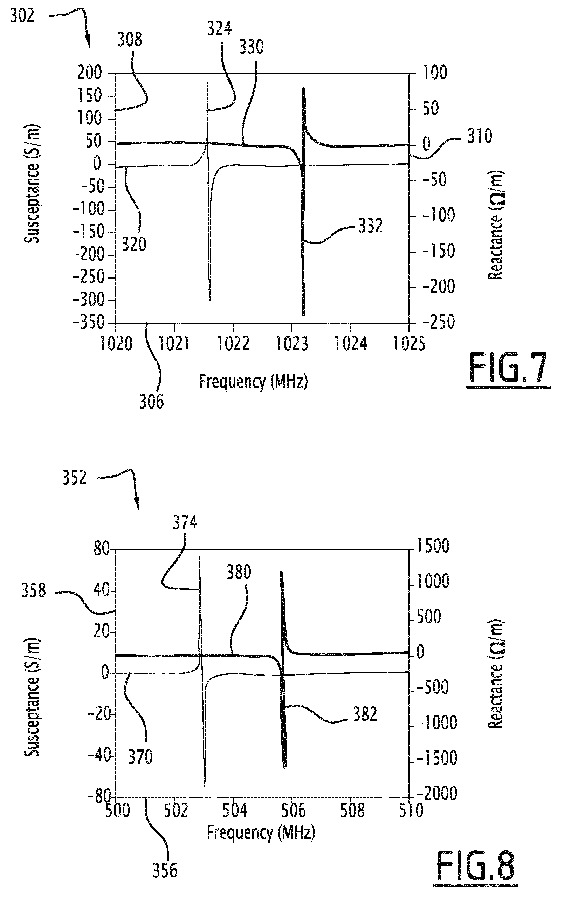

Les Figures 7 et 8 représentent respectivement des résultats de simulation dans le premier cas, c'est-à-dire le cas dans lequel la hauteur $\underline{h}$ de la couche de nitrure d'aluminium est proche de $\lambda bulk/4$, pour une structure de transducteur classique et une structure de transducteur de l'invention.

Les résultats de simulation montrent que les caractéristiques de résonance de la structure de transducteur de l'invention de la Figure 3 diffèrent radicalement de celles d'une structure classique avec une couche piézoélectrique uniforme.

Les caractéristiques de résonance des transducteurs sont représentées en termes d'évolution de l'admittance harmonique des dispositifs « transducteurs », calculée pour une période et pour 1 m d'ouverture acoustique.

Suivant la Figure 7, les caractéristiques de résonance 302 de la structure de transducteur classique sont représentées dans un repère ayant un axe d'abscisses 306 de la fréquence d'excitation ft, un premier axe d'ordonnées 308, situé à gauche sur la Figure 7, d'évolution de la susceptance harmonique exprimée en Siemens par mètre (S/m), et un deuxième axe d'ordonnées 310, situé à droite sur la Figure 7, d'évolution de la réactance harmonique exprimée en Ohms par mètre ($\Omega$/m). Un pôle au sens mathématique du terme sur ces courbes de susceptance (partie imaginaire de l'admittance) et de réactance (partie imaginaire de l'impédance) harmoniques rend compte de l'existence d'un vrai mode de la surface correspondant à une propagation d'ondes sans pertes. L'écart relatif en fréquences entre un pôle de l'admittance et le pôle correspondant de l'impédance rend compte de l'efficacité de couplage électromécanique du mode ainsi caractérisé.

Une première courbe 320 qui représente l'évolution en fonction de la fréquence de la susceptance, c'est-à-dire la partie imaginaire de l'admittance, comporte une résonance 324.

Une deuxième courbe 330 qui représente l'évolution en fonction de la fréquence de la réactance, c'est-à-dire la partie imaginaire de l'impédance, comporte une antirésonance 332 correspondant à la résonance 324.

Pour la structure classique avec couche piézoélectrique uniforme, on peut voir que la résonance correspondant à l'excitation des ondes de Rayleigh à une fréquence proche de 1 GHz comme prévu.

Suivant la Figure 8, les caractéristiques de résonance 352 de la structure de transducteur de l'invention sont représentées dans un repère ayant un axe d'abscisses 356 de la fréquence d'excitation ft, un premier axe d'ordonnées 358 d'évolution de la susceptance, c'est-à-dire la partie imaginaire de l'admittance, exprimée en S/m et un deuxième axe d'ordonnées 360 d'évolution de la réactance, c'est-à-dire la partie imaginaire de l'impédance, exprimée en Ω/m.

Une première courbe 370 qui représente l'évolution de la susceptance en fonction de la fréquence comporte une résonance 374.

Une deuxième courbe 380 qui représente l'évolution de la réactance en fonction de la fréquence comporte une antirésonance 382.

Suivant la Figure 8, pour la structure de l'invention, les ondes de Rayleigh sont fortement ralenties par effet de surcharge massique appelé « mass loading » en anglais, et la résonance s'avère à environ 500 MHz. Le couplage des ondes au sein de la nouvelle structure est d'environ 3,5 fois plus grand que dans le cas classique.

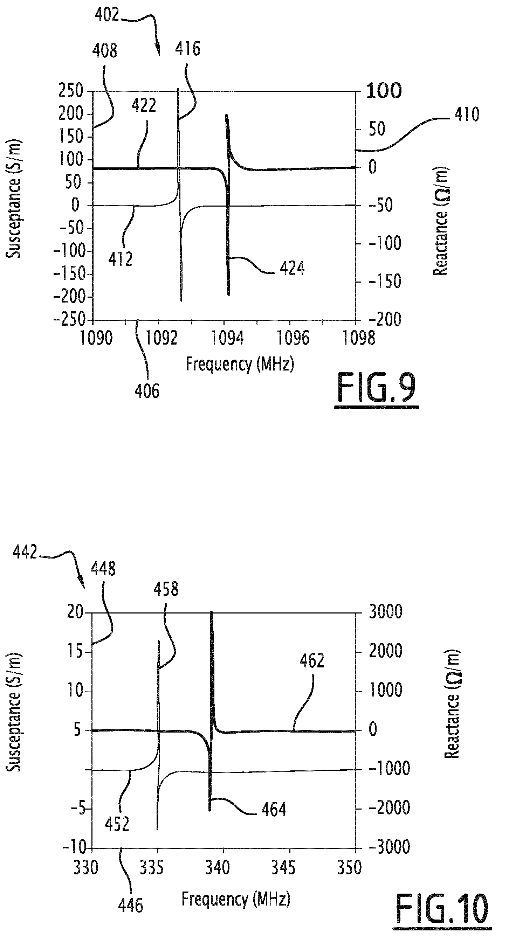

Les Figures 9, 10 et 11 représentent respectivement des résultats de simulation dans le deuxième cas, c'est-à-dire le cas dans lequel la hauteur $\underline{h}$ de la couche de nitrure d'aluminium est proche de λ.bulk/2, pour un premier mode de résonance d'une structure de transducteur classique, pour un premier et un deuxième mode de résonance d'une structure de transducteur de l'invention.

Les résultats de simulation montrent que les caractéristiques de résonance de la structure de transducteur de l'invention de la Figure 3 diffèrent radicalement de celles d'une structure classique avec une couche piézoélectrique uniforme.

Les caractéristiques de résonance des transducteurs sont représentées en termes d'évolution de la susceptance et de la réactance des dispositifs « transducteurs », calculée pour une période et pour 1 m d'ouverture acoustique.

Suivant la Figure 9, les caractéristiques de résonance 402 de la structure de transducteur de l'invention sont représentées dans un repère ayant un axe d'abscisse 406 de variation de la fréquence d'excitation ft, un premier axe d'ordonnées 408, situé à gauche sur la Figure 9 d'évolution de la susceptance, c'es à dire la partie imaginaire de l'admittance, exprimée en S/m et un deuxième axe d'ordonnées 410, situé à droite de la Figure 9, d'évolution de la réactance, c'est à dire la partie imaginaire de l'impédance, exprimée en Ω/m.

Une première courbe 412 qui représente l'évolution de la susceptance en fonction de la fréquence comporte une première résonance 416.

Une deuxième courbe 422 qui représente l'évolution de la réactance en fonction de la fréquence comporte une première antirésonance 424 correspondant à la première résonance 416.

Pour la structure classique avec couche piézoélectrique uniforme, on peut voir que la résonance correspondant à l'excitation des ondes de Rayleigh à une fréquence proche de 1 GHz comme prévu.

Suivant la Figure 10, les caractéristiques de résonance 422 de la structure de transducteur de l'invention sont représentées dans un repère pour un premier mode de résonance correspondant au premier mode de résonance de la structure classique décrit dans la Figure 9.

Le repère comporte un axe d'abscisses 446 de la fréquence d'excitation ft, un premier axe d'ordonnées 448 d'évolution de la susceptance exprimée en S/m et un deuxième axe d'ordonnées 450 d'évolution de la réactance exprimée en Ω/m.

Une première courbe 452 qui représente l'évolution de la susceptance en fonction de la fréquence comporte une première résonance 458.

Une deuxième courbe 462 qui représente l'évolution de la réactance en fonction de la fréquence comporte une première antirésonance 464.

Suivant la Figure 10, pour la structure de l'invention, les ondes de Rayleigh sont fortement ralenties par effet de surcharge massique appelé « mass loading » en anglais, et la résonance s'avère à environ 350 MHz. Le couplage des ondes au sein de la nouvelle structure est d'environ 3,5 fois plus grand que dans le cas classique.

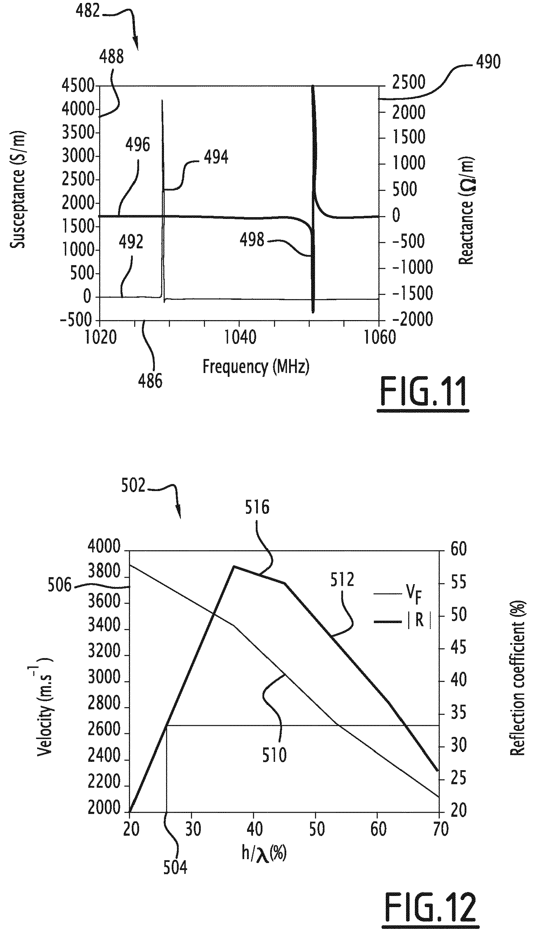

Suivant la Figure 11, les caractéristiques de résonance 482 de la structure de transducteur de l'invention sont représentées pour un deuxième mode de résonance dans un repère ayant un axe d'abscisses 486 de la fréquence d'excitation ft, un premier axe d'ordonnées 488 d'évolution de la susceptance, c'est-à-dire la partie imaginaire de l'admittance, exprimée en S/m et un deuxième axe d'ordonnées 490 d'évolution de la réactance, c'est-à-dire la partie imaginaire de l'impédance, exprimée en Ω/m.

Une première courbe 492 qui représente l'évolution de la susceptance en fonction de la fréquence comporte une deuxième résonance 494 correspondant à un deuxième et nouveau mode.

Une deuxième courbe 496 qui représente l'évolution de la réactance en fonction de la fréquence comporte une deuxième antirésonance 498 correspondant à la deuxième résonance 494.

Suivant la Figure 11, le deuxième mode de résonance est un nouveau mode mis en évidence à 1 GHz conforme à l'onde longitudinale de volume dans le nitrure d'aluminium.

Ainsi, si la résonance des ondes longitudinales de volume de la couche piézoélectrique s'avère inférieure au seuil de rayonnement en ondes de volume (ici 1130 MHz, correspondant à vitesse de ondes transversale de volume de 5650 m.s$^{-1}$ dans le silicium), un mode supplémentaire se produit, présentant au moins 10 fois plus de couplage électromécanique que celui du mode guidé sur couche uniforme (4.0 % dans le cas de la figue 11 qui peut dépasser 4.2 % selon l'épaisseur de couche, sans véritable effort d'optimisation avancée).

Suivant la Figure 12, l'évolution en fonction de la hauteur h du barreau de nitrure d'aluminium normalisée par la longueur d'onde du mode de surface des caractéristiques 502 du premier mode de résonance est représentée dans un repère décrit ci-après.Ce repère comprend un axe d'abscisse 504 de variation de la hauteur h normalisée par la longueur d'onde λ du mode de surface, un premier axe d'ordonnées 506 de la vitesse de phase de l'onde élastique du mode de surface exprimée en m/s, définie par la somme des fréquences d'entrée et de sortie de la bande d'arrêt propre au mode à la condition de Bragg divisée par deux, et un deuxième axe d'ordonnées 508 du coefficient de réflexion acoustique de l'onde du mode de surface à l'entrée d'une cellule élémentaire proportionnel à la largeur relative de la bande d'arrêt exprimé en pourcentage.

Une première courbe 510 représente la vitesse de phase de l'onde élastique décroissant en fonction de l'épaisseur du barreau.

Une deuxième courbe 512 représente l'évolution du coefficient de réflexion en fonction de l'épaisseur du barreau normalisé.

Le coefficient de réflexion dépasse 33% pour une hauteur h comprise entre 25% et 60%.

Il apparaît ainsi que le premier mode de résonance de la structure à barreau existe encore pour ces épaisseurs et pour de plus fortes épaisseurs de nitrure d'aluminium, supérieures à 5 $\mu$m, c'est-à-dire plus grandes que la période p de la structure et présente un couplage électro-acoustique dépassant 2 %.

Il est à remarquer que le mode de surface du transducteur 102 ne correspond pas à une onde de surface classique mais à un système de résonateurs FBARs couplés. Imposer un changement de phase de 180 degrés entre oscillateurs voisins est équivalent à forcer la structure périodique à fonctionner dans sa bande d'arrêt.

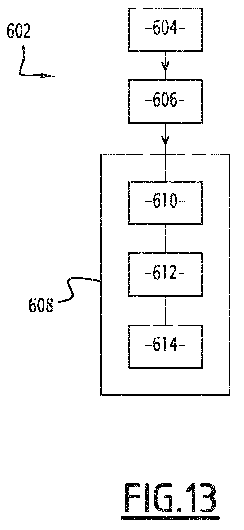

Suivant la Figure 13 un procédé de fabrication 602 d'un transducteur à ondes de volume guidées en surface décrit dans les Figures 1 à 4 comprend un ensemble d'étapes 604, 606, 608, 610, 612 et 614.

Le transducteur est destiné à fonctionner à une longueur d'onde acoustique λ et à convertir un signal électrique à une fréquence de travail correspondant à la longueur d'onde acoustique λ en une onde de volume guidée en surface et réciproquement.

Dans la première étape 604, un substrat acoustique est réalisé sous la forme d'une plaque, formant une première couche en un premier matériau électriquement isolant, monocristallin ou polycristallin, coupée selon trois plans d'une première coupe cristalline définis par un premier angle φ, un deuxième angle θ, et un troisième angle ψ définis par la nomenclature (YX*wlt*)/φ/θ/ψ du standard IEEE Std-176 (révision 1949).

La plaque est étendue selon une première épaisseur t1, une première longueur l1 et une première largeur w1, la plaque du substrat acoustique ayant une première face de repos et, en vis-à-vis dans le sens de la première épaisseur t1, une deuxième face de support opposée ayant un état de rugosité.

La coupe cristalline du premier matériau est choisie et l'état de rugosité de la deuxième face est suffisamment lisse pour permettre la propagation d'ondes élastiques de Rayleigh ou de Bleustein-Gulyaev ou de pseudo-ondes de surface (PSAW) dans le sens de la première longueur l1 du substrat acoustique.

Dans l'étape suivante 606, un plan de masse est réalisé sous la forme d'une deuxième couche en un deuxième matériau électriquement conducteur qui est déposée sur le substrat acoustique du coté de sa deuxième face.

La deuxième couche est étendue selon une deuxième épaisseur uniforme t2, une deuxième largeur w2, et une deuxième longueur l2, la deuxième couche ayant une troisième face, disposée en vis à vis de la deuxième face du substrat acoustique, et ayant une quatrième face opposée et en vis-à-vis de la troisième face dans le sens de la deuxième épaisseur t2, les directions de la deuxième épaisseur e2, la deuxième largeur w2, la deuxième longueur l2 étant respectivement les mêmes que les directions de la première épaisseur e1, la première largeur w1, la deuxième longueur l2.

Le deuxième matériau est acoustiquement perméable à des ondes élastiques générées par piézoélectricité

Dans l'étape suivante 608 un réseau de sources d'excitation acoustique synchrone est réalisé en étant disposé sur le plan de masse.

Le réseau est configuré pour être relié mécaniquement et électriquement à une source électrique d'excitation synchrone, et comprend un premier peigne d'un ou plusieurs transducteurs piézoélectriques élémentaires rangés selon une première direction et un deuxième peigne d'un ou plusieurs transducteurs piézoélectriques élémentaires rangés selon une deuxième direction opposée à la première de sorte que les transducteurs piézoélectriques élémentaires du premier peigne et du deuxième peigne soient entrelacées alternativement deux à deux suivant un pas périodique p de réseau et selon la direction de propagation des ondes élastiques de surface le long de la deuxième face de support dans le sens de la première longueur l1 du substrat acoustique.

Le premier peigne et le deuxième peigne possèdent le même nombre de transducteurs piézoélectriques élémentaires.

Le double du pas de réseau 2p est égal sensiblement à la longueur d'onde acoustique λ;

Chaque transducteur élémentaire comporte un barreau unique et différent et une électrode supérieure métallique d'excitation électrique unique et différente.

Chaque barreau est réalisé en un troisième matériau piézoélectrique, monocristallin ou polycristallin, coupé selon trois plans d'une deuxième coupe cristalline définis suivant la nomenclature (YX*wlt*)/φ/θ/ψ du standard IEEE Std-176 (révision 1949) par un deuxième angle φ2, un deuxième angle θ2, et un troisième angle ψ2. Chaque barreau possède une même forme parallélépipédique définie par une troisième épaisseur h, une troisième largeur $\underline{d}$, et une troisième longueur L, possède une cinquième face en vis de la face du plan de masse et une sixième face, opposée à la cinquième face et sur laquelle est déposée l'électrode d'excitation associée.

Le troisième matériau et la deuxième coupe sont choisis pour permettre la propagation d'ondes élastiques de volume dans le sens de la troisième épaisseur h avec un coefficient de couplage élevé au moins supérieur ou égal à 0,1%.

La troisième épaisseur $\underline{h}$ est comprise entre un quart et trois quarts de la longueur d'onde λbulk du mode acoustique de volume se propageant au sein du troisième matériau dans le sens de la troisième épaisseur h et correspondant à la fréquence de travail ft.

La troisième largeur $\underline{d}$ est strictement inférieure à la moitié de la longueur d'onde acoustique λ du mode de surface et de même orientation que la direction de propagation des ondes de volume guidées en surface du substrat acoustique.

Deux transducteurs élémentaires adjacents sont séparés entre eux dans le sens de leur troisième largeur $\underline{d}$ par un espace d'écartement de longueur d'écartement $\overline{D}$ non nulle, la somme de la troisième largeur d et de la longueur d'écartement D étant égale au pas p du réseau.

Dans un mode de réalisation préféré, l'étape 608 de réalisation du réseau de sources d'excitation acoustique synchrone comprend successivement une étape 610 de dépôt d'une couche homogène du troisième matériau piézoélectrique sur le plan de masse, une étape de dépôt 612 d'une couche homogène métallique sur la couche homogène du troisième matériau piézoélectrique, et une étape de gravure 614 de couche homogène du troisième matériau et de la couche homogène métallique pour former les transducteurs piézoélectriques élémentaires du réseau d'excitation.

L'étape de gravure 614 est réalisée par un procédé compris dans l'ensemble formé par un procédé de gravure chimique, un procédé de gravure par irradiation d'ions, et un procédé de sciage/polissage mécanique. En variante le procédé de gravure par irradiation d'ions peut intégrer une étape de gravure chimique en phase gazeuse, voire une alternance de bombardement ionique et de gravure chimique en phase gazeuse.

En variante, le réseau des sources d'excitation est fabriqué en étant au préalable séparé du plan de masse et du substrat acoustique, puis fixé sur le substrat acoustique au travers du plan de masse par collage, en respectant les orientations relatives cristallographiques des barreaux transducteurs et du substrat acoustique.

En variante, un mode pur de vibrations transversales dans la couche piézoélectrique est permis en choisissant une orientation adaptée de LiNbO₃ (coupe (YXl)/163° par exemple) ou une orientation d'AlN avec l'axe « C » incliné par rapport à la normale du plan de réalisation (d'un angle de 45° par exemple), ou avec l'axe C idéalement dans le plan de propagation.

En variante, l'utilisation de substrats compensés des effets de température permet de minimiser le Coefficient de Température de la Fréquence (CTF) du mode étudié. Aussi, une couche de passivation mince sur l'électrode supérieure, voire intercalée entre l'une des électrodes (c'est-à-dire le plan de masse ou l'électrode supérieure d'excitation et la couche piézoélectrique), permet de résoudre ce problème.

Dans un autre mode de réalisation de l'invention, des structures plus épaisses que celles de la Figure 1 permettent d'exciter des modes harmoniques potentiellement exploitables pour diverses applications (capteurs, sources) pour lesquelles l'impératif de pureté spectrale est moindre que pour les filtres. Des structures plus fines sont également envisageables pour l'excitation de modes à haute vitesse de phase, sans permettre cependant d'atteindre des couplages aussi élevés que ceux accessibles dans les configurations décrites dans les Figures 1 à 4.

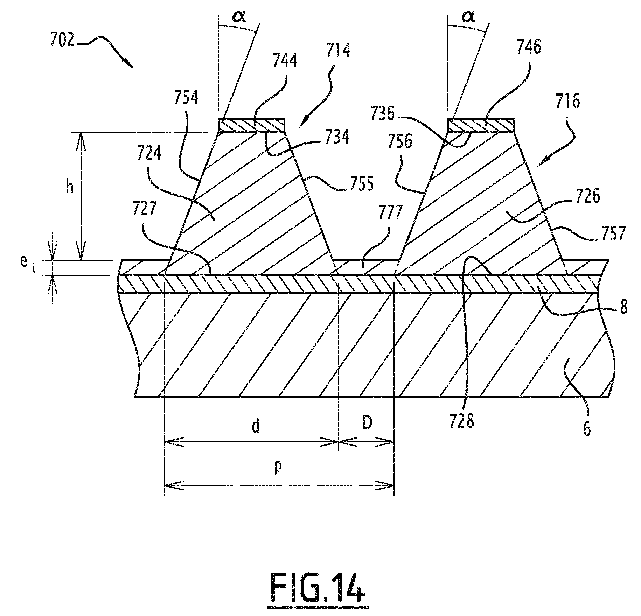

En variante des Figures 1 à 4 et suivant la Figure 14, un transducteur 702, dérivé des transducteurs 2 ou 102 comprend au moins deux transducteurs élémentaires, deux transducteurs 714 et 716 étant seulement représentés sur la Figure 14.

Le barreau 724, 726 respectivement associé de chaque transducteur piézoélectrique élémentaire 714, 716 possède une même forme profilée de lingot ayant une section trapézoïdale.

Chaque barreau 724, 226 comporte une cinquième face respective 727, 728 en vis à vis de la face du plan de masse 8, une sixième face respective 734, 736, opposée à la cinquième face correspondante 727, 728 et sur laquelle est déposée l'électrode d'excitation associée 744, 746, et deux flancs latéraux 754, 755 ; 756, 757 reliant de part et d'autre la cinquième face 727 ; 728 et la sixième face 734 ; 736.

La troisième épaisseur $\underline{h}$ est définie comme étant la hauteur séparant la cinquième face 727, 728 et la sixième face respectivement associée 734, 736. La troisième largeur $\underline{d}$ de recouvrement du plan de masse 8 est définie comme la largeur de la sixième face 727, 728. La troisième longueur L non représentable sur la Figure 14 est la longueur d'extension de chaque barreau 724, 726.

La largeur de la sixième face 734, 736 est strictement inférieure à la largeur de la sixième face 727, 728.

L'angle de dépouille noté α sur la Figure 14 est l'angle aigu formé entre la normale de la cinquième face 734, 736 et la direction transverse du flan de gauche 754, 756 orientée dans le même sens que la normale de la cinquième face, c'est à dire le demi-plan supérieur sur la Figure 14.

On suppose ici que l'angle de dépouille défini par le flan de droit 755, 757 possède une valeur sensiblement identique à celle de α.

L'angle de dépouille α est supposé ici le même pour chaque barreau.

Dans tous les cas, l'angle de dépouille est inférieur ou égal à 30 degrés.

Cette variante englobe notamment ainsi la réalisation de structures de peignes pour lesquelles l'angle d'attaque de la gravure imparfaite n'est pas parfaitement orthogonal à la face du plan de masse.

En variante, et comme illustré dans l'exemple de la Figure 14, une couche interstitielle 777, constituée en le même troisième matériau que les barreaux 724 726, est déposée entre les barreaux 724, 726 des transducteurs élémentaires adjacents 714, 716. L'épaisseur de la couche interstitielle notée et doit être inférieure au quart de la troisième épaisseur $\underline{h}$ telle définie ci-dessus.

La couche interstitielle 777 et les barreaux piézoélectriques 724, 726 sont d'un seul tenant lorsqu'ils sont réalisés par un procédé de gravure d'une couche originelle en le troisième matériau.

La principale application visée par l'invention concerne les filtres pour les télécommunications civiles, militaires et spatiales.

L'invention peut également viser à la fabrication de structures résonantes pour les oscillateurs ainsi que pour les capteurs. L'utilisation de matériaux de haute qualité réfractaire autorise en particulier les applications de haute température (entre 500 et 1000°C) comme expliqué ci-dessous.

Une application secondaire concerne les résonateurs à hauts facteurs de qualité pour les sources de fréquence faible bruit.

Une autre application de l'invention concerne les capteurs à haute compacité en général, plus particulièrement les capteurs de température dans une gamme étendue (depuis des températures cryogéniques aux très hautes températures, pouvant aller au-delà de 500°C et potentiellement jusqu'à 1000°C), des capteurs de type accéléromètre, des capteurs gyroscopiques, gravimétriques capables de fonctionner en milieux liquides (utilisation d'ondes de cisaillement en particulier).

De manière avantageuse, l'invention permet de réaliser des résonateurs à ondes de volume sur tranches de façon collective mais dans une géométrie inédite pour tirer parti de propriétés de mono-cristaux remarquables en termes de vitesses de propagation et de minimisation des pertes intrinsèques aux matériaux exploités. Elle se prête particulièrement à des fréquences de travail allant de quelques centaines de MHz jusqu'à plusieurs GHz.

Elle permet des modes de connexion entre résonateurs particulièrement avantageuses pour les structures de filtres à port équilibrés (en anglais dénommé "balanced"), mais surtout l'utilisation d'ondes de volume dans des structures à forts coefficients de couplage et de qualité de la résonance. La combinaison de telles structures avec des couches de propriétés choisies permet par ailleurs d'optimiser les propriétés des composants correspondants, par exemple la compensation des effets de température avec des couches de silice ou avec des matériaux permettant l'excitation d'ondes de cisaillement sur quartz, langasite (et ses diverses variantes), orthophosphate de gallium et de façon générale de matériaux présentant un CTF positif des ondes ainsi excitées. Ceci n'est qu'un exemple des possibilités offertes par l'invention qui permet donc de réaliser des dispositifs inédits dans une bande de fréquence largement exploitée pour les applications de télécommunication et de métrologie.

L'invention permet ainsi de résoudre le problème de la fabrication de résonateurs acousto-électriques à films minces pour les applications radiofréquences.

Avantageusement, les transducteurs à réseau de transducteurs en barreaux offrent une alternative avantageuse à la fabrication de structures sur films minces qui sont par définition fragiles. En effet, ces nouvelles structures à barreaux sont fermement attachées au substrat et offrent un élément de maîtrise des fréquences de travail par lithographie haute résolution inaccessible aux structures classiques à ondes de volume pour lesquelles seule l'épaisseur du film conditionne la résonance.

**Revendications**

1. - Transducteur à ondes de volume guidées en surface, destiné à fonctionner à une longueur d'onde acoustique de surface λ et à convertir un signal électrique à une fréquence de travail ft correspondant à la longueur d'onde acoustique λ en une onde de volume guidée en surface et réciproquement, comprenant un substrat acoustique (6) et un plan de masse électrique (8),

le substrat acoustique étant réalisé sous la forme d'une plaque formant une première couche en un premier matériau électriquement isolant, monocristallin ou polycristallin coupée selon trois plans d'une première coupe cristalline définis suivant la nomenclature (YX*wlt*)/φ/θ/ψ du standard IEEE Std-176 (révision 1949) par un premier angle φ, un deuxième angle θ, et un troisième angle ψ, la plaque de substrat (6) étant étendue selon une première épaisseur t1, une première longueur l1 et une première largeur w1, la plaque du substrat acoustique (6) ayant une première face de repos (12) et, en vis-à-vis dans le sens de la première épaisseur t1, une deuxième face de support (14) opposée ayant un état de rugosité, la coupe cristalline du premier matériau étant choisie et l'état de rugosité de la deuxième face (14) étant suffisamment lisse pour permettre la propagation d'ondes élastiques de Rayleigh ou de Bleustein-Gulyaev ou des pseudo-ondes de surface (PSAW) dans le sens de la première longueur l1 du substrat acoustique (6),

le plan de masse (8) étant réalisé sous la forme d'une deuxième couche en un deuxième matériau électriquement conducteur, déposée sur le substrat acoustique (6) du coté de sa deuxième face (14), la deuxième couche étant étendue selon une deuxième épaisseur uniforme t2, une deuxième largeur w2, et une deuxième longueur l2, la deuxième couche ayant une troisième face (16), disposée en vis à vis de la deuxième face (14) du substrat acoustique, et ayant une quatrième face (18) opposée et en vis-à-vis de la troisième face (16) dans le sens de la deuxième épaisseur t2, les directions de la deuxième épaisseur t2, la deuxième largeur w2, la deuxième longueur l2 étant respectivement les mêmes que les directions de la première épaisseur t1 , la première largeur w1, la première longueur l1 ;

**caractérisé en ce que**

le transducteur à ondes de volume guidées en surface comprend un réseau (10 ; 110) de sources d'excitation acoustiques synchrones, configuré pour être relié mécaniquement et électriquement à une source électrique d'excitation synchrone, déposé sur le plan de masse (8), et comportant un premier peigne (32 ; 112) d'un ou plusieurs transducteurs piézoélectriques élémentaires (34 ; 122, 124, 126, 130) rangés selon une première direction et un deuxième peigne (36 ; 114) d'un ou plusieurs transducteurs piézoélectriques élémentaires (38 ; 124, 128, 132) dans le même nombre que ceux du premier peigne rangés selon une deuxième direction opposée à la première de sorte que les transducteurs piézoélectriques élémentaires (34, 38 ; 122, 124, 126, 128, 130, 132) du premier peigne (32; 112) et du deuxième peigne (38; 114) soient entrelacées alternativement deux à deux suivant un pas périodique p de réseau et selon la direction de propagation des ondes élastiques de surface le long de la deuxième face de support dans le sens de la première longueur l1 du substrat acoustique, le double du pas de réseau 2p étant égal sensiblement à la longueur d'onde acoustique λ;

chaque transducteur élémentaire (34, 38 ; 122, 124, 126, 128, 130, 132) comporte un barreau unique et différent et une électrode métallique supérieure d'excitation électrique unique et différente (54, 58 ; 142, 144, 146, 148, 150, 152), le barreau étant réalisé en un troisième matériau piézoélectrique, monocristallin ou polycristallin, coupé selon trois plans d'une deuxième coupe cristalline définis suivant la nomenclature (YX$wlt$)/φ/θ/ψ du standard IEEE Std-176 (révision 1949) par un deuxième angle φ2, un deuxième angle θ2, et un troisième angle ψ2, ayant une même forme profilée de section rectangulaire ou trapézoïdale, ayant une cinquième face (64, 66) en vis de la face du plan de masse (8), une sixième face (68, 70) opposée à la cinquième face (64, 66) sur laquelle est déposée l'électrode d'excitation associée (54, 58), et deux flancs latéraux reliant de part et d'autre la cinquième face (64, 66) et la sixième face (68, 70), et définie par une troisième épaisseur h comme étant la hauteur séparant la cinquième face (64, 66) et la sixième face (68, 70), une troisième largeur d de recouvrement du plan de masse (8) et une troisième longueur L;

le troisième matériau et la deuxième coupe étant choisis pour permettre la propagation d'ondes élastiques de volume dans le sens de la troisième épaisseur h avec un coefficient de couplage élevé au moins supérieur ou égal à 0,1%, et

la troisième épaisseur h est comprise entre un quart et trois quarts de la longueur d'onde λbulk du mode élastique de volume se propageant au sein du troisième matériau dans le sens de la troisième épaisseur et correspondant à la fréquence de travail ft ;

la troisième largeur d étant strictement inférieure à la moitié de la longueur d'onde acoustique et de même orientation que la direction de propagation des ondes de volume guidées en surface du substrat acoustique ;

deux transducteurs élémentaires adjacents étant séparés entre eux dans le sens de leur troisième largeur par un espace d'écartement de longueur d'écartement D non nulle, la somme de la troisième largeur d et de la longueur d'écartement D étant égal au pas p du réseau, et

le deuxième matériau est acoustiquement perméable à des ondes élastiques générées par piézoélectricité.

**2.** - Transducteur à ondes de volume guidées en surface selon la revendication 1, dans lequel le premier peigne (32, 112) et le deuxième peigne (36, 114) comprennent chacun un nombre de transducteurs élémentaires supérieur à deux, de préférence supérieur à 5.

**3.** - Transducteur à ondes de volume guidées en surface selon l'une quelconque des revendications 1 à 2, dans lequel la deuxième coupe cristallographique du deuxième matériau est choisie de façon à permettre l'excitation piézoélectrique d'ondes élastiques de volume se propageant dans chaque transducteur élémentaire dans le sens de la troisième épaisseur, ces ondes étant soit des ondes de déformation essentiellement longitudinale, soit des ondes de déformation essentiellement transversale.

**4.** - Transducteur à réseau de sources selon l'une quelconque des revendications 1 à 3, dans lequel la troisième épaisseur h de chaque transducteur élémentaire est comprise soit entre 0,9 fois λbulk/2 et 1,1 fois λbulk/2 soit entre 0,9 fois λbulk/4 et 1,1 fois λbulk/4, et réglée de façon qu'un niveau de résonance maximal soit atteint dans chacun des transducteur élémentaires.

5. - Transducteur à ondes de volume guidées en surface selon l'une quelconque des revendications 1 à 4, dans lequel
le premier matériau est compris dans l'ensemble formé par le saphir, le diamant, le silicium, le YAG (Yttrium Aluminium Garnet ou grenat d'yttrium et d'aluminium en français - dits grenats alumineux) et autres composés à base de grenat (grenats ferrifères ou chromifères), le quartz fondu, le quartz cristallin, le niobate de lithium, le tantalate de lithium, la langasite et ses variantes notamment la langanite et la langatate, ainsi que l'orthophosphate de gallium, le deuxième matériau est compris dans l'ensemble formé par les métaux Al, Mo, Pt, W, Cu, Ni, Au, Ag et les alliages AlCu, AlTi, AlSi, et Ti/Pt, Ta/Pt, et le troisième matériau est compris dans l'ensemble formé par le nitrure d'aluminium, le nitrure d'aluminium dopé au scandium, l'oxyde de zinc, le PZT, le niobate de lithium, le tantalate de lithium, le quartz cristallin, la langasite et ses variantes, l'orthophosphate de gallium, le niobate de potassium et les relaxeurs de type PMN-PT et autres variantes de cette nature.

6. - Transducteur à ondes de volume guidées en surface selon l'une quelconque des revendications 1 à 5, dans lequel le premier matériau du substrat acoustique (6) est de préférence le quartz amorphe ou cristallisé, la langasite et ses variantes notamment la langanite et la langatate, l'orthophosphate de gallium, le tétraborate de lithium le niobate de potassium, le tantalate de lithium de façon à compenser les effets de température de dérive observés pour des ondes de volume générées par les transducteurs élémentaires et à polarisation transverse dans le sens de la troisième longueur L.

7. - Transducteur à ondes de volume guidées en surface selon l'une quelconque des revendications 1 à 6, dans lequel la longueur L de chaque transducteur élémentaire (34, 38; 122, 124, 126, 128, 130, 132) est supérieure à dix fois la longueur d'onde acoustique λ des ondes de volume guidées en surface du substrat acoustique (6).

8. - Transducteur selon l'une quelconque des revendications 1 à 7, dans lequel le pas p de répétition des transducteurs (34, 38 ; 122, 124, 126, 128, 130, 132) est réglé en fonction d'une longueur d'onde de surface caractéristique d'une onde élastique de surface de la famille comprenant les ondes de Rayleigh, les ondes Bleustein-Gulyaev, les ondes STW, les ondes de Sezawa pour permettre l'excitation efficace des ondes de surface sur une zone de surface externe située en dehors et dans le prolongement de la région du réseau des transducteurs élémentaires.

9. - Transducteur à ondes de volume guidées en surface selon l'une quelconque des revendications 1 à 8, dans lequel soit le plan de masse (8), situé entre les transducteurs élémentaires adjacents est exposé, soit une couche de troisième matériau dont l'épaisseur est inférieur au quart de la troisième épaisseur h est déposée entre les transducteurs élémentaires adjacents.

10. - Transducteur à ondes de volume guidées en surface selon l'une quelconque des revendications 1 à 9, dans lequel chaque transducteur piézoélectrique élémentaire comprend une couche d'un matériau acoustique de compensation des effets de dérive de la fréquence en température, interposée soit entre le barreau piézoélectrique et le plan de masse (8), soit entre le barreau piézoélectrique et l'électrode supérieure d'excitation associée, le matériau de compensation en température pouvant être par exemple de la silice amorphe.

11. - Transducteur à ondes de volume guidées en surface selon l'une quelconque des revendications 1 à 10, dans lequel les barreaux ont une même forme profilée de section trapézoïdale, et dans lequel pour chaque barreau l'angle dépouille formé entre la normale de la cinquième face et une direction transverse orienté dans le même sens que la normale est inférieur à 30 degrés.

12. - Procédé de fabrication d'un transducteur à ondes de volume guidées en surface, destiné à fonctionner à une longueur d'onde acoustique λ et à convertir un signal électrique à une fréquence correspondant à la longueur d'onde acoustique λ en une onde de volume guidée en surface et réciproquement, comprenant les étapes consistant à
dans une étape (604) un substrat acoustique est réalisé sous la forme d'une plaque formant un première couche en un premier matériau électriquement isolant, monocristallin ou polycristallin coupée selon trois plans d'une première coupe cristalline définis suivant la nomenclature (*YXwlt*)/φ/θ/ψ du standard IEEE Std-176 (révision 1949) par un premier angle φ, un deuxième angle θ, et un troisième angle ψ, la plaque étant étendue selon une première épaisseur t1, une première longueur l1 et une première largeur w1, la plaque du substrat acoustique (6) ayant une première face de repos et, en vis-à-vis dans le sens de la première épaisseur t1, une deuxième face de support opposée ayant un état de rugosité, la coupe cristalline du premier matériau étant choisie et l'état de rugosité de la deuxième face étant suffisamment lisse pour permettre la propagation d'ondes élastiques de Rayleigh ou de Bleustein-Gulyaev ou de pseudo-ondes de surface (PSAW) dans le sens de la première longueur l1 du substrat acoustique, et dans une étape suivante (606) un plan de masse est réalisé sous la forme d'une deuxième couche en un deuxième matériau électriquement conducteur, déposée sur le substrat acoustique du coté de sa deuxième face, la deuxième couche étant étendue selon une deuxième épaisseur uniforme t2, une deuxième largeur w2, et une deuxième longueur l2, la deuxième couche ayant une troisième face, disposée en vis à vis de la deuxième face du substrat acoustique, et ayant une quatrième face opposée et en vis-à-vis de la troisième face dans le sens de la deuxième épaisseur t2, les directions de la deuxième épaisseur t2,

la deuxième largeur w2, la deuxième longueur l2 étant respectivement les mêmes que les directions de la première épaisseur t1 la première largeur w1, la première longueur l1, et le deuxième matériau étant acoustiquement perméable à des ondes élastiques générées par piézoélectricité;

**caractérisé en ce que**

le procédé comprend en outre une étape consistant **en ce que**

dans une étape suivante (608) un réseau de sources d'excitation acoustique synchrone est réalisé en étant disposé sur le plan de masse, le réseau étant configuré pour être relié mécaniquement et électriquement à une source électrique d'excitation synchrone, et comportant un premier peigne d'un ou plusieurs transducteurs piézoélectriques élémentaires rangés selon une première direction et un deuxième peigne d'un ou plusieurs transducteurs piézoélectriques élémentaires dans le même nombre que ceux du premier peigne rangés selon une deuxième direction opposée à la première de sorte que les transducteurs piézoélectriques élémentaires du premier peigne et du deuxième peigne soient entrelacées alternativement deux à deux suivant un pas périodique p de réseau et selon la direction de propagation des ondes élastiques de surface le long de la deuxième face de support dans le sens de la première longueur l1 du substrat acoustique, le double du pas de réseau 2p étant égal sensiblement à la longueur d'onde acoustique λ;

chaque transducteur élémentaire comportant un barreau unique et différent et une électrode métallique supérieure d'excitation unique et différente, le barreau étant réalisé en un troisième matériau piézoélectrique, monocristallin ou polycristallin, coupé selon trois plans d'une deuxième coupe cristalline définis suivant la nomenclature (YX*wlt*)/φ/θ/ψ du standard IEEE Std-176 (révision IRE 1949) par un deuxième angle φ2, un deuxième angle θ2, et un troisième angle ψ2, ayant une même forme profilée de section rectangulaire ou trapézoïdale, ayant une cinquième face en vis de la face du plan de masse, une sixième face opposée à la cinquième face sur laquelle est déposée l'électrode d'excitation associée, et deux flancs latéraux reliant de part et d'autre la cinquième face et la sixième face, et définie par une troisième épaisseur h comme la hauteur séparant la cinquième face et la sixième face, une troisième largeur d de recouvrement du plan de masse et une troisième longueur L;

le troisième matériau et la deuxième coupe étant choisis pour permettre la propagation d'ondes élastiques de volume dans le sens de la troisième épaisseur h avec un coefficient de couplage élevé au moins supérieur ou égal à 0,1%, et

la troisième épaisseur h étant comprise entre un quart et trois quarts de la longueur d'onde λbulk du mode élastique de volume se propageant au sein du troisième matériau dans le sens de la troisième épaisseur et correspondant à la fréquence de travail ft ;

la troisième largeur d étant strictement inférieure à la moitié de la longueur d'onde acoustique et de même orientation que la direction de propagation des ondes de volume guidées en surface du substrat acoustique ;

deux transducteurs élémentaires adjacents étant séparés entre eux dans le sens de leur troisième largeur par un espace d'écartement de longueur d'écartement D non nulle, la somme de la troisième largeur d et de la longueur d'écartement D étant égal au pas p du réseau.

13. - Transducteur excité de manière synchrone et exploitant des ondes de volume guidées en surface ayant une longueur d'onde acoustique prédéterminée comprenant

- un transducteur (2 ; 102) défini selon l'une quelconque des revendications 1 à 8, et
- une source de tension différentielle (4) ayant une première borne de sortie et une deuxième borne de sortie dont les polarités en tension appliquées sont inverse l'une de l'autre, la première borne de sortie étant connectée au premier peigne et la deuxième borne de sortie étant connectée au deuxième peigne.

**Patentansprüche**

1. Wandler für oberflächengeführte Volumenwellen, welcher dazu bestimmt ist, bei einer Länge der akustischen Oberflächenwelle λ zu arbeiten und ein elektrisches Signal mit einer Arbeitsfrequenz ft, welche mit einer Länge der akustischen Welle λ korrespondiert, in eine oberflächengeführte Volumenwelle zu wandeln und umgekehrt, aufweisend ein akustisches Substrat (6) und eine elektrische Massefläche (8),

wobei das akustische Substrat (6) in der Form einer Platte realisiert ist, welche eine erste Schicht bildet aus einem ersten elektrisch isolierenden, monokristallinen oder polykristallinen Material, welches gemäß drei Ebenen eines ersten Kristallschnitts geschnitten ist, welche nach der Nomenklatur (YXwlt)/φ/θ/ψ des Standards IEEE Std-176 (Fassung 1949) durch einen ersten Winkel φ, einen zweiten Winkel θ und einen dritten Winkel ψ definiert sind, wobei die Platte des Substrats (6) sich gemäß einer ersten Dicke t1, einer ersten Länge 11 und einer ersten Breite w1 erstreckt, wobei die Platte des akustischen Substrats (6) eine erste Ruhefläche (12) und, in der Richtung der ersten Dicke t1 gegenüberliegend, eine zweite entgegengesetzte Stützfläche (14), welche einen Rauigkeitszustand hat, hat, wobei der Kristallschnitt des ersten Materials gewählt ist und der Rauigkeitszustand der zweiten Fläche (14) geeignet glatt ist, um die Ausbreitung von elastischen Rayleigh-Wellen oder Bleustein-Gulyaev-Wellen oder Pseudo-Oberflächenwellen (PSAW) in der Richtung der ersten Länge 11 des akustischen Substrats (6) zu erlauben,

wobei die Massefläche (8) realisiert ist in der Form einer zweiten Schicht aus einem zweiten, elektrisch leitfähigen Material, welches auf dem akustischen Substrat (6) auf der Seite seiner zweiten Fläche (14) aufgebracht ist, wobei die zweite Schicht sich gemäß einer zweiten gleichmäßigen Dicke t2, einer zweiten Breite w2 und einer zweiten Länge 12 erstreckt, wobei die zweite Schicht eine dritte Fläche (16), welche der zweiten Fläche (14) des akustischen Substrats gegenüberliegend angeordnet ist, hat und eine vierte Fläche (18), welche entgegengesetzt und gegenüberliegend der dritten Fläche (16) in der Richtung der zweiten Dicke t2 ist, hat, wobei die Richtungen der zweiten Dicke t2, der zweiten Breite w2, der zweiten Länge 12 jeweilig dieselben sind wie die Richtung der ersten Dicke t1, der ersten Breite w1, der ersten Länge 11;

**gekennzeichnet dadurch, dass**

der Wandler für oberflächengeführte Volumenwellen aufweist ein Gitter (10; 110) von synchronen, akustischen Anregungsquellen, welches dazu eingerichtet ist, mechanisch und elektrisch mit einer elektrischen Quelle zur synchronen Anregung verbunden zu sein, auf der Massefläche (8) aufgebracht ist und aufweist einen ersten Kamm (32; 112) aus einem oder mehreren piezoelektrischen Elementarwandlern (34; 122, 124, 126, 130), welche gemäß einer ersten Richtung geordnet sind, und einen zweiten Kamm (36; 114) aus einem oder mehreren piezoelektrischen Elementarwandlern (38; 124, 128, 132) in derselben Anzahl wie die des ersten Kamms, welche gemäß einer zweiten Richtung geordnet sind, welche der ersten entgegengesetzt ist, so dass die piezoelektrischen Elementarwandler (34, 38; 122, 124, 126, 128, 130, 132) des ersten Kamms (32; 112) und des zweiten Kamms (38; 114) abwechselnd paarweise verschachtelt sind gemäß einem periodischen Abstand p des Gitters und gemäß der Richtung der Ausbreitung der elastischen Oberflächenwellen entlang der zweiten Stützfläche in der Richtung der ersten Länge 11 des akustischen Substrats, wobei das Doppelte des Abstands des Gitters 2p im Wesentlichen gleich der Länge der akustischen Welle λ ist,

wobei jeder Elementarwandler (34, 38; 122, 124, 126, 128, 130, 132) einen einzelnen und anderen Stab und eine einzelne und andere, metallische, obere Elektrode zur elektrischen Anregung (54, 58; 142, 144, 146, 148, 150, 152) aufweist, wobei der Stab aus einem dritten piezoelektrischen, monokristallinen oder polykristallinen Material, welches gemäß drei Ebenen eines zweiten Kristallschnitts geschnitten ist, welche nach der Nomenklatur (YXwlt)/φ/θ/ψ des Standards IEEE Std-176 (Fassung 1949) durch einen zweiten Winkel φ2, einen zweiten Winkel θ2 und einen dritten Winkel ψ2 definiert sind, realisiert ist, eine gleiche profilierte Form eines rechteckigen oder trapezförmigen Querschnitts hat, welche eine zur Fläche der Massefläche (8) weisende, fünfte Fläche (64, 66), eine der fünften Fläche (64, 66) entgegengesetzte, sechste Fläche (68, 70), auf welcher die zugehörige Elektrode zur Anregung (54, 58) aufgebracht ist, und zwei seitliche Flanken hat, die die fünfte Fläche (64, 66) und die sechste Fläche (68, 70) beidseits verbinden, und welche durch eine dritte Dicke h wie die Höhe, die die fünfte Fläche (64, 66) und die sechste Fläche (68, 70) trennt, eine dritte Breite d der Abdeckung der Massefläche (8) und eine dritte Länge L definiert ist,

wobei das dritte Material und der zweite Schnitt gewählt sind, um die Ausbreitung der elastischen Volumenwellen in der Richtung der dritten Dicke h mit einem hohen Kopplungskoeffizienten, welcher wenigstens größer oder gleich 0,1% ist, zu erlauben, und

wobei die dritte Dicke h zwischen einem Viertel und drei Viertel der Wellenlänge Abulk der elastischen Volumenmode, welche sich in dem dritten Material in der Richtung der dritten Dicke ausbreitet und mit der Arbeitsfrequenz ft korrespondiert,

wobei die dritte Breite d streng kleiner ist als die Hälfte der Länge der akustischen Welle und von derselben Orientierung wie die Richtung der Ausbreitung der auf der Oberfläche des akustischen Substrats geführten Volumenwellen ist,

wobei zwei benachbarte Elementarwandler in der Richtung ihrer dritten Breite durch einen Abstandsraum der Abstandslänge D nicht Null voneinander getrennt sind, wobei die Summe der dritten Breite d und der Abstandslänge D gleich dem Abstand p des Gitters ist, und

wobei das zweite Material für durch Piezoelektrität erzeugte elastische Wellen akustisch permeabel ist.

**2.** Wandler für oberflächengeführte Volumenwellen gemäß dem Anspruch 1, wobei der erste Kamm (32, 112) und der zweite Kamm (36, 114) jeweils eine Zahl von Elementarwandlern größer zwei, bevorzugt größer fünf, aufweisen.

**3.** Wandler für oberflächengeführte Volumenwellen gemäß irgendeinem der Ansprüche 1 bis 2, wobei der zweite kristallographische Schnitt des zweiten Materials gewählt ist, um die piezoelektrische Anregung der elastischen Volumenwellen, welche sich in jedem Elementarwandler in der Richtung der dritten Dicke ausbreitet, erlaubt ist, wobei diese Wellen entweder Wellen der im wesentlichen longitudinalen Verformung oder Wellen der im wesentlichen transversalen Verformung sind.

**4.** Quellengitterwandler gemäß irgendeinem der Ansprüche 1 bis 3, wobei die dritte Dicke h von jedem Elementarwandler entweder zwischen 0,9 mal Abulk/2 und 1,1 mal Abulk/2 oder zwischen 0,9 mal Abulk/4 und 1,1 mal Abulk/4 liegt und derart eingestellt ist, dass ein maximales Resonanzniveau in jedem der Elementarwandler erreicht ist.

**5.** Wandler für oberflächengeführte Volumenwellen gemäß irgendeinem der Ansprüche 1 bis 4, wobei das erste Material vorliegt in der Gruppe, welche gebildet ist durch den Saphir, den Diamanten, das Silizium, das YAG (auf Französisch Yttrium-Aluminium-Granat oder Granat aus Yttrium und Aluminium - genannt aluminiumhaltiges Granat) und andere Zusammensetzungen auf Basis von Granat (eisenhaltige oder chromhaltige Granate), den geschmolzenen Quarz, den kristallinen Quarz, das Lithiumniobat, das Lithiumtantalat, das Langasit und dessen Varianten, insbesondere das Langanat und das Langatat, sowie das Galliumorthophosphat,
das zweite Material vorliegt in der Gruppe, welche gebildet ist durch die Metalle Al, Mo, Pt, W, Cu, Ni, Au, Ag und die Legierungen AlCu, AlTi, AlSi und Ti/Pt, Ta/Pt, und
das dritte Material vorliegt in der Gruppe, welche gebildet ist durch das Aluminiumnitrid, das mit Scandium dotierte Aluminiumnitrid, das Zinkoxid, das PZT, das Lithiumniobat, das Lithiumtantalat, den kristallinen Quarz, das Langasit und dessen Varianten, das Galliumorthophosphat, das Kaliumniobat, und die Relaxoren vom Typ PMN-PT und andere derartige Varianten.

**6.** Wandler für oberflächengeführte Volumenwellen gemäß irgendeinem der Ansprüche 1 bis 5, wobei das erste Material des akustischen Substrats (6) vorzugsweise der amorphe oder kristalline Quarz, das Langasit und dessen Varianten, insbesondere das Langanat und das Langatat, das Galliumorthophosphat, das Lithiumtetraborat das Kaliumniobat, das Lithiumtantalat ist zur Kompensation der Temperatureffekte des Driftens, welche für die durch die Elementarwandler erzeugten Volumenwellen beobachtet werden, und zur transversalen Polarisierung in der Richtung der dritten Länge L.

**7.** Wandler für oberflächengeführte Volumenwellen gemäß irgendeinem der Ansprüche 1 bis 6, wobei die Länge L von jedem Elementarwandler (34, 38; 122, 124, 126, 128, 130, 132) größer ist als zehn Mal die Länge der akustischen Welle λ der auf der Oberfläche des akustischen Substrats (6) geführten Volumenwelle.

**8.** Wandler für oberflächengeführte Volumenwellen gemäß irgendeinem der Ansprüche 1 bis 7, wobei der Abstand p der Wiederholung der Wandler (34, 38; 122, 124, 126, 128, 130, 132) abhängig von der Länge der Oberflächenwelle, die charakteristisch ist für eine elastische Oberflächenwelle der Familie, welche die Rayleigh-Wellen, die Bleustein-Gulyaev-Wellen, die STW-Wellen, die Sezawa-Wellen aufweist, eingestellt ist, um die wirksame Anregung der Oberflächenwellen auf einer Zone der äußeren Fläche, welche außerhalb von und in der Verlängerung der Region des Gitters der Elementarwandler angeordnet ist, zu erlauben.

**9.** Wandler für oberflächengeführte Volumenwellen gemäß irgendeinem der Ansprüche 1 bis 8, wobei entweder die Massefläche (8), welche zwischen den benachbarten Elementarwandlern angeordnet ist, exponiert ist oder eine Schicht des dritten Materials, dessen Dicke kleiner ist als ein Viertel der dritten Dicke h, zwischen den benachbarten Elementarwandlern aufgebracht ist.

**10.** Wandler für oberflächengeführte Volumenwellen gemäß irgendeinem der Ansprüche 1 bis 9, wobei jeder piezoelektrische Elementarwandler aufweist eine Schicht eines akustischen Materials zur Kompensation von Drifteffekten der Frequenz mit der Temperatur, welche entweder zwischen dem piezoelektrischen Stab und der Massefläche (8) oder zwischen dem piezoelektrischen Stab und der zugehörigen oberen Elektrode zur Anregung angeordnet ist, wobei das Material zur Temperaturkompensation beispielsweise aus dem amorphen Silizium sein kann.

**11.** Wandler für oberflächengeführte Volumenwellen gemäß irgendeinem der Ansprüche 1 bis 10, wobei die Stäbe eine gleiche profilierte Form eines trapezförmigen Querschnitts haben, und wobei, für jeden Stab, der Freiwinkel, welcher zwischen der Normalen der fünften Fläche und einer Querrichtung, welche in die gleiche Richtung wie die Normale gerichtet ist, kleiner als 30 Grad ist.

**12.** Verfahren zum Herstellen eines Wandlers für oberflächengeführte Volumenwellen, welcher dazu bestimmt ist, bei einer Länge der akustischen Welle λ zu arbeiten und ein elektrisches Signal mit einer Arbeitsfrequenz ft, welche mit einer Länge der akustischen Welle λ korrespondiert, in eine oberflächengeführte Volumenwelle zu wandeln und umgekehrt, aufweisend die Schritte bestehend daraus, dass in einem Schritt (604) ein akustisches Substrat in der Form einer Platte realisiert wird, welche eine erste Schicht bildet aus einem ersten elektrisch isolierenden, monokristallinen oder polykristallinen Material, welches gemäß drei Ebenen eines ersten Kristallschnitts geschnitten ist, welche nach der Nomenklatur (YXwlt)/φ/θ/ψ des Standards IEEE Std-176 (Fassung 1949) durch einen ersten Winkel φ, einen zweiten Winkel θ und einen dritten Winkel ψ definiert sind, wobei die Platte sich gemäß einer ersten Dicke t1, einer ersten Länge 11 und einer ersten Breite w1 erstreckt, wobei die Platte des akustischen Substrats (6) eine erste Ruhefläche und in der Richtung der ersten Dicke t1 gegenüberliegend eine zweite entgegengesetzte Stützfläche, welche einen Rauigkeitszustand hat, hat, wobei der Kristallschnitt des ersten Materials gewählt ist und der Rauigkeitszustand der zweiten Fläche geeignet glatt ist, um die Ausbreitung von elastischen Rayleigh-Wellen oder Bleustein-Gulyaev-Wellen oder Pseudo-Oberflächenwellen (PSAW) in der Richtung der ersten Länge 11 des akustischen Substrats (6) zu erlauben, und

in einem nachfolgenden Schritt (606) eine Massefläche realisiert wird in der Form einer zweiten Schicht aus einem zweiten, elektrisch leitfähigen Material, welches auf dem akustischen Substrat auf der Seite seiner zweiten Fläche aufgebracht ist, wobei die zweite Schicht sich gemäß einer zweiten gleichmäßigen Dicke t2, einer zweiten Breite w2 und einer zweiten Länge 12 erstreckt, wobei die zweite Schicht eine dritte Fläche, welche der zweiten Fläche des akustischen Substrats gegenüberliegend angeordnet ist, hat und eine vierte Fläche, welche entgegengesetzt und gegenüberliegend der dritten Fläche (16) in der Richtung der zweiten Dicke t2 ist, hat, wobei die Richtungen der zweiten Dicke t2, der zweiten Breite w2, der zweiten Länge 12 jeweilig dieselben sind wie die Richtung der ersten Dicke t1, der ersten Breite w1, der ersten Länge 11, und wobei das zweite Material für durch Piezoelektrizität erzeugte elastische Wellen akustisch permeabel ist; **gekennzeichnet dadurch, dass** das Verfahren ferner einen Schritt aufweist, welcher daraus besteht, dass in einem nachfolgenden Schritt (608) ein Gitter von Quellen zur synchronen, akustischen Anregung realisiert wird durch Anordnen auf der Massefläche, wobei das Gitter dazu eingerichtet ist, mechanisch und elektrisch mit einer elektrischen Quelle zur synchronen Anregung verbunden zu sein, und aufweist einen ersten Kamm aus einem oder mehreren piezoelektrischen Elementarwandlern, welche gemäß einer ersten Richtung geordnet sind, und einen zweiten Kamm aus einem oder mehreren piezoelektrischen Elementarwandlern in derselben Anzahl wie die des ersten Kamms, welche gemäß einer zweiten Richtung, welche der ersten entgegengesetzt ist, geordnet sind, so dass die piezoelektrischen Elementarwandler des ersten Kamms und des zweiten Kamms abwechselnd paarweise verschachtelt sind gemäß einem periodischen Abstand p des Gitters und gemäß der Richtung der Ausbreitung der elastischen Oberflächenwellen entlang der zweiten Stützfläche in der Richtung der ersten Länge 11 des akustischen Substrats, wobei das Doppelte des Abstands des Gitters 2p im Wesentlichen gleich der Länge der akustischen Welle λ ist,

wobei jeder Elementarwandler einen einzelnen und anderen Stab und eine einzelne und andere, metallische, obere Elektrode zur elektrischen Anregung aufweist, wobei der Stab aus einem dritten piezoelektrischen, monokristallinen oder polykristallinen Material, welches gemäß drei Ebenen eines zweiten Kristallschnitts geschnitten ist, welche nach der Nomenklatur (YXwlt)/φ/θ/ψ des Standards IEEE Std-176 (Fassung IRE 1949) durch einen zweiten Winkel φ2, einen zweiten Winkel θ2 und einen dritten Winkel ψ2 definiert sind, realisiert ist, eine gleiche profilierte Form eines rechteckigen oder trapezförmigen Querschnitts hat, welche eine zur Fläche der Massefläche weisende, fünfte Fläche, eine der fünften Fläche entgegengesetzte, sechste Fläche, auf welcher die zugehörige Elektrode zur Anregung aufgebracht ist, und zwei seitliche Flanken hat, die die fünfte Fläche und die sechste Fläche beidseits verbinden, und welche durch eine dritte Dicke h wie die Höhe, die die fünfte Fläche und die sechste Fläche trennt, eine dritte Breite d der Abdeckung der Massefläche und eine dritte Länge L definiert ist,

wobei das dritte Material und der zweite Schnitt gewählt sind, um die Ausbreitung der elastischen Volumenwellen in der Richtung der dritten Dicke h mit einem hohen Kopplungskoeffizienten, welcher wenigstens größer oder gleich 0,1% ist, zu erlauben, und

wobei die dritte Dicke h zwischen einem Viertel und drei Viertel der Wellenlänge Abulk der elastischen Mode des Volumens, welche sich in dem dritten Material in der Richtung der dritten Dicke ausbreitet und mit der Arbeitsfrequenz ft korrespondiert, wobei die dritte Breite d streng kleiner ist als die Hälfte der Länge der akustischen Welle und von derselben Orientierung wie die Richtung der Ausbreitung der auf der Oberfläche des akustischen Substrats geführten Volumenwellen ist,

wobei zwei benachbarte Elementarwandler in der Richtung ihrer dritten Breite durch einen Abstandsraum der Abstandslänge D nicht Null voneinander getrennt sind, wobei die Summe der dritten Breite d und der Abstandslänge D gleich dem Abstand p des Gitters ist.

13. Wandler, welcher auf synchrone Weise angeregt ist und welcher oberflächengeführte Volumenwellen, welche eine vorbestimmte Länge einer akustischen Welle haben, nutzt, aufweisend

   - einen Wandler (2; 102), welcher nach irgendeinem der Ansprüche 1 bis 8 definiert ist, und
   - eine Quelle von differenzieller Spannung (4), welche einen ersten Ausgangsanschluss und einen zweiten Ausgangsanschluss hat, deren angelegte Spannungspolaritäten zueinander umgekehrt sind, wobei der erste Ausgangsanschluss mit dem ersten Kamm verbunden ist und der zweite Ausgangsanschluss mit dem zweiten Kamm verbunden ist.

## Claims

1. A surface guided bulk wave transducer, intended to operate at an acoustic surface wavelength A and to convert an electric signal at an operating frequency ft corresponding to the acoustic wavelength A into a surface-guided bulk wave and vice versa, comprising an acoustic substrate (6) and an electric ground plane (8),
the acoustic substrate being made as a plate forming a first layer in a first single crystal or polycrystalline electrically insulating material cut along three planes of a first crystalline cut defined according to the nomenclature (YX$wlt$)/$\varphi$/$\theta$/$\psi$ of the IEEE Std-176 standard (1949 revision) by a first angle $\varphi$, a second angle $\theta$, and a third angle $\psi$, the substrate plate (6) being extended along a first thickness t1, a first length l1 and a first width w1, the plate of the acoustic substrate (6) having a first rest face (12) and facing, in the direction of the first thickness t1, a second opposite supporting face (14) having a roughness condition, the crystalline cut of the first material being selected and the roughness condition of the second face (14) being sufficiently smooth for allowing propagation of elastic Rayleigh or Bleustein-Gulyaev elastic waves or pseudo-surface waves (PSAW) in the direction of the first length l1 of the acoustic substrate (6),
the ground plane (8) being made as a second layer in a second electrically conducting material, deposited on the acoustic substrate (6) on the side of its second face (14), the second layer being extended along a second uniform thickness t2, a second width w2, and a second length l2, the second layer having a third face (16), positioned facing the second face (14) of the acoustic substrate, and having a fourth opposite face (18) and facing the third face (16) in the direction of the second thickness t2, the directions of the second thickness t2, the second width w2, the second length l2 respectively being the same as the directions of the first thickness t1, the first width w1, the second length l2;
**characterized in that**
the surface-guided bulk wave transducer comprises a network (10; 110) of synchronous acoustic excitation sources, configured so as to be mechanically and electrically connected to a synchronous excitation electric source, deposited on the ground plane (8), and including a first comb (32; 112) of one or several elementary piezoelectric transducers (34; 122, 124, 126, 130) arranged along a first direction and a second comb (36; 114) of one or several elementary piezoelectric transducers (38; 124, 128, 132) in the same number as those of the first comb arranged along a second direction opposite to the first so that the elementary piezoelectric transducers (34, 38; 122, 124, 126, 128, 130, 132) of the first comb (32; 112) and of the second comb (38; 114) are alternately interlaced two-by-two according to a periodic network step p and along the propagation direction of the elastic surface waves along the second supporting face in the direction of the first length l1 of the acoustic substrate, double the network step 2p being substantially equal to the acoustic wavelength $\lambda$;
each elementary transducer (34, 38; 122, 124, 126, 128, 130, 132) includes a single and different rod and a single and different electric excitation upper metal electrode (54, 58; 142, 144, 146, 148, 150, 152), the rod being produced in a third single crystal or polycrystalline piezoelectric material, cut along three planes of a second crystalline cut defined according to the nomenclature (YX$wlt$)/$\varphi$/$\theta$/$\psi$ of the IEEE Std-176 standard (1949 revision) by a second angle $\varphi 2$, a second angle $\theta 2$, and a third angle $\psi 2$, having a same profiled shape with a rectangular or trapezoidal section, having a fifth face (64, 66) facing the face of the ground plane (8), a sixth face (68, 70) opposite to the fifth face (64, 66) on which is deposited the associated excitation electrode (54, 58), and two side flanks connecting from both sides the fifth face (64, 66) and the sixth face (68, 70), and defined by a third thickness h as being the height separating the fifth face (64, 66) and the sixth face (68, 70), a third width d for covering the ground plane (8) and a third length L;
the third material and the second cut being selected so as to allow propagation of elastic bulk waves in the direction of the third thickness $\underline{h}$ with a high coupling coefficient at least greater than or equal to 0.1 %, and
the third thickness $\underline{h}$ is comprised between a quarter and three quarters of the wavelength $\lambda_{bulk}$ of the elastic bulk mode propagating within the third material in the direction of the third thickness and corresponding to the operating frequency ft;

the third width d being strictly less than half the acoustic wavelength and with a same orientation as the propagation direction of the surface-guided bulk waves of the acoustic substrate;

two adjacent elementary transducers being separated from each other in the direction of their third width by a separation space of a non-zero separation length D, the sum of the third width $\underline{d}$ and of the separation length D being equal to the step p of the network, and

the second material is acoustically pervious to elastic waves generated by piezoelectricity.

2. The surface-guided bulk wave transducer according to claim 1, wherein the first comb (32, 112) and the second comb (36, 114) each comprise a number of elementary transducers of more than two, preferably more than 5.

3. The surface-guided bulk wave transducer according to any of claims 1 to 2, wherein the second crystallographic cut of the second material is selected so as to allow piezoelectric excitation of elastic bulk waves propagating in each elementary transducer in the direction of the third thickness, these waves either being essentially longitudinal deformation waves, or essentially transverse deformation waves.

4. The transducer with a network of sources according to any of claims 1 to 3, wherein the third thickness $\underline{h}$ of each elementary transducer is either comprised between 0.9 times $\lambda_{bulk}/2$ and 1.1 times $\lambda_{bulk}/2$ or between 0.9 times $\lambda_{bulk}/4$ and 1.1 times $\lambda_{bulk}/4$, and adjusted so that a maximum resonance level is attained in each of the elementary transducers.

5. The surface-guided bulk wave transducer according to any of claims 1 to 4, wherein
the first material is comprised in the set formed by sapphire, diamond, silicon, YAG (Yttrium-Aluminium-Garnet - so-called aluminous garnets) and other compounds based on garnet (iron-containing or chromium-containing garnets), fused quartz, crystalline quartz, lithium niobate, lithium tantalate, langasite and its variants, notably langanite and langatate, as well as gallium orthophosphate,
the second material is comprised in the set formed by the metals Al, Mo, Pt, W, Cu, Ni, Au, Ag and the alloys AlCu, AlTi, AlSi, and Ti/Pt, Ta/Pt, and
the third material is comprised in the set formed by aluminium nitride, aluminium nitride doped with scandium, zinc oxide, PZT, lithium niobate, lithium tantalate, crystalline quartz, langasite and its variants, gallium orthophosphate, potassium niobate and relaxers of the PMN-PT type and other variants of this nature.

6. The surface-guided bulk wave transducer according to any of claims 1 to 5, wherein the first material of the acoustic substrate (6) is preferably amorphous or crystallized quartz, langasite and its variants, notably langanite and langatate, gallium orthophosphate, lithium tetraborate, potassium niobate, lithium tantalate so as to compensate for the temperature drift effects observed for bulk waves generated by the elementary transducers and with a transverse polarization in the direction of the third length L.

7. The surface-guided bulk wave transducer according to any of claims 1 to 6, wherein the length L of each elementary transducer (34, 38; 122, 124, 126, 128, 130, 132) is greater than ten times the acoustic wavelength $\lambda$ of the surface-guided bulk waves of the acoustic substrate (6).

8. The transducer according to any of claims 1 to 7, wherein the repetition step p of the transducers (34, 38; 122, 124, 126, 128, 130, 132) is adjusted according to a surface wavelength characteristic of an elastic surface wave of the family comprising Rayleigh waves, Bleustein-Gulyaev waves, STW waves, Sezawa waves for allowing effective excitation of the surface waves on an external surface area located outside and in the extension of the region of the network of the elementary transducers.

9. The surface-guided bulk wave transducer according to any of claims 1 to 8, wherein either the ground plane (8), located between the adjacent elementary transducers is exposed, or a layer of a third material for which the thickness is less than a quarter of the third thickness $\underline{h}$ is deposited between the adjacent elementary transducers.

10. The surface-guided bulk wave transducer according to any of claims 1 to 9, wherein each elementary piezoelectric transducer comprises a layer of an acoustic material for compensating the frequency drift effects of temperature, interposed either between the piezoelectric rod and the ground plane (8), or between the piezoelectric rod and the associated excitation upper electrode, the temperature compensation material may for example be amorphous silica.

11. The surface-guided bulk wave transducer according to any of claims 1 to 10, wherein the rods have a same profiled shape with a trapezoidal section, and wherein for each rod, the clearance angle formed between the normal of the fifth face and a transverse direction oriented in the same direction as the normal is less than 30°.

12. A method for manufacturing a surface-guided bulk wave transducer, intended to operate at an acoustic

wavelength $\lambda$ and to convert an electric signal at a frequency corresponding to the acoustic wavelength $\lambda$ into a surface-guided bulk wave and vice versa, comprising the steps:

in a step (604), an acoustic substrate is produced as a plate forming a first layer in a first single crystal or polycrystalline electrically insulating material cut along three planes of a first crystalline cut defined according to the nomenclature (YX*wlt*)/$\varphi$/$\theta$/$\psi$ of the IEEE Std-176 standard (1949 revision) by a first angle $\varphi$, a second angle $\theta$, and a third angle $\psi$, the plate being extended along a first thickness t1, a first length l1 and a first width w1, the plate of the acoustic substrate (6) having a first rest face and facing, in the direction of the first thickness t1, a second opposite supporting face having a roughness condition, the crystalline cut of the first material being selected and the roughness condition of the second face being sufficiently smooth for allowing propagation of elastic Rayleigh or Bleustein-Gulyaev waves or pseudo surface waves (PSAW) in the direction of the first length l1 of the acoustic substrate, and
in a next step (606), a ground plane is produced as a second layer in a second electrically conducting material, deposited on the acoustic substrate on the side of its second face, the second layer being extended along a second uniform thickness t2, a second width w2, and a second length l2, the second layer having a third face, positioned facing the second face of the acoustic substrate, and having a fourth face opposite and facing the third face in the direction of the second thickness t2, the directions of the second thickness t2, the second width w2, the second length l2 respectively being the same as the directions of the first thickness t1, the first width w1, the first length l1, and the second material being acoustically pervious to elastic waves generated by piezoelectricity;

**characterized in that**

the method further comprises a step consisting **in that**
in a next step (608), a network of synchronous acoustic excitation sources is produced by being positioned on the ground plane, the network being configured so as to be mechanically and electrically connected to a synchronous excitation electric source, and including a first comb of one or several elementary piezoelectric transducers arranged along a first direction and a second comb of one or several elementary piezoelectric transducers in the same number as those of the first comb arranged along a second direction opposite to the first so that the elementary piezoelectric transducers of the first comb and of the second comb are alternately interlaced two-by-two according to a periodic network step p and along the propagation direction of the elastic surface waves along the second supporting face in the direction of the first length l1 of the acoustic substrate, double the network step 2p being substantially equal to the acoustic wavelength $\lambda$;
each elementary transducer including a single and different rod and a single and different excitation upper metal electrode, the rod being produced in a third single crystal or polycrystalline piezoelectric material, cut along three planes of a second crystalline cut defined according to the nomenclature (YX*wlt*)/$\varphi$/$\theta$/$\psi$ of the IEEE Std-176 standard (1949 revision) by a second angle $\varphi 2$, a second angle $\theta 2$, and a third angle $\psi 2$, having a same profiled shape with a rectangular or trapezoidal section, having a fifth face facing the face of the ground plane, a sixth face opposite to the fifth face on which is deposited the associated excitation electrode, and two side flanks connecting from both sides the fifth face and the sixth face, and defined by a third thickness h like the height separating the fifth face and the sixth face, a third width d for covering the ground plane and a third length L;
the third material and the second cut being selected so as to allow propagation of elastic bulk waves in the direction of the third thickness h with a high coupling coefficient at least greater than or equal to 0.1 %, and
the third thickness h being comprised between one quarter and three quarters of the wavelength $\lambda_{bulk}$ of the elastic bulk mode propagating within the third material in the direction of the third thickness h and corresponding to the operating frequency ft;
the third width $\underline{d}$ being strictly less than half of the acoustic wavelength and with the same orientation as the propagation direction of the surface-guided bulk waves of the acoustic substrate;
two adjacent elementary transducers being separated from each other in the direction of their third width by a separation space of a non-zero separation length D, the sum of the third width $\underline{d}$ and of the separation length D being equal to the step p of the network.

13. A synchronously excited transducer utilizing surface-guided bulk waves having a predetermined acoustic wavelength comprising

- a transducer (2; 102) defined according to any of claims 1 to 8, and

- a differential voltage source (4) having a first output terminal and a second output terminal, for which the applied voltage polarities are opposite to each other, the first output terminal being connected to the first comb and the second output terminal being connected to the second comb.

**FIG.1**

FIG.3

EP 2 909 932 B1

FIG.2

FIG.4

FIG.5

FIG.6

FIG.7

FIG.8

FIG.9

FIG.10

FIG.11

FIG.12

602

-604-

-606-

608

-610-

-612-

-614-

# FIG.13

## FIG.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2938136

- FR 2882205 B1

**Littérature non-brevet citée dans la description**

- **SYLVAIN BALLANDRAS ; WILLIAM STEICHEN.** Composants acoustiques utilisés pour le filtrage - Modèles et outils de simulation. *les Techniques de l'Ingénieur,* 10 Novembre 2010